# EUROPÄISCHE PATENTSCHRIFT

(11) **EP 1 675 929 B1**
(45) Veröffentlichungstag und Bekanntmachung des Hinweises auf die Patenterteilung: **22.06.2011**
(21) Anmeldenummer: 04765652.5
(22) Anmeldetag: 28.09.2004
(51) Int. Cl.: C09K 11/06

(54) **METALLKOMPLEXE**
METAL COMPLEXES
COMPLEXES METALLIQUES

(30) Priorität: 29.09.2003 DE 10345572
(43) Veröffentlichungstag der Anmeldung: 05.07.2006
(73) Patentinhaber: Merck Patent GmbH, 64293 Darmstadt (DE)
(72) Erfinder: FORTTE, Rocco, 65933 Frankfurt (DE); STÖSSEL, Philipp, 60487 Frankfurt (DE); GERHARD, Anja, 64291 Darmstadt (DE); VESTWEBER, Horst, 34830 Gilserberg-Winterscheid (DE)
(86) Internationale Anmeldenummer: PCT/EP2004/010836
(87) Internationale Veröffentlichungsnummer: WO 2005/033244

(56) Entgegenhaltungen:
- EP-A- 1 348 711
- US-A- 4 128 650
- US-A- 4 461 895

## Beschreibung

Die vorliegende Erfindung beschreibt neue Materialien und Materialmischungen, deren Verwendung in organischen elektronischen Bauteilen wie Elektrolumineszenzelementen und darauf basierende Displays.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten. Der Einsatz spezieller halbleitender organischer Verbindungen, die zum Teil auch zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die organischen lichtemittierenden Dioden (OLEDs), besitzen ein sehr breites Anwendungsspektrum als:
1. weiße oder farbige Hinterleuchtungen für monochrome oder mehrfarbige Anzeigeelemente (z. B. Taschenrechner, Mobiltelefone, etc.),
2. großflächige Anzeigen (z. B. Verkehrsschilder, Plakate, etc.),
3. Beleuchtungselemente in allen Farben und Formen,
4. monochrome oder vollfarbige Passiv-Matrix-Displays für tragbare Anwendungen (z. B. Mobiltelefone, PDAs, Camcorder, etc.),
5. vollfarbige großflächige hochaufgelöste Aktiv-Matrix-Displays für verschiedenste
Anwendungen (z. B. Mobiltelefone, PDAs, Laptops, Fernseher, etc.). Bei diesen Anwendungen ist die Entwicklung teilweise bereits sehr weit fortgeschritten. So ist für einfache OLEDs enthaltende Vorrichtungen die Markteinführung bereits erfolgt, wie die Autoradios der Firma Pioneer oder eine Digitalkamera der Firma Kodak mit "Organischem Display" belegen; dennoch besteht immer noch großer Bedarf an technischen Verbesserungen.

Eine Entwicklung hierzu, die sich in den letzten Jahren abzeichnet, ist der Einsatz metallorganischer Komplexe, die Phosphoreszenz statt Fluoreszenz zeigen [M. A. Baldo, S. Lamansky, P. E. Burrows, M. E. Thompson, S. R. Forrest, Appl. Phys. Lett. 1999, 75, 4-6]. Aus quantenmechanischen Gründen ist unter Verwendung metallorganischer Verbindungen eine bis zu vierfache Quanten-, Energie- und Leistungseffizienz möglich. Ob sich diese Entwicklung durchsetzen wird, hängt stark davon ab, ob entsprechende Device-Kompositionen gefunden werden können, die diese Vorteile (Triplettemission = Phosphoreszenz gegenüber Singulettemission = Fluoreszenz) auch in OLEDs umsetzen können. Als wesentliche Bedingungen für die praktische Anwendung sind hier insbesondere eine hohe operative Lebensdauer, eine hohe thermische Stabilität und eine niedrige Einsatz- und Betriebsspannung, um mobile Applikationen zu ermöglichen, zu nennen.

Der allgemeine Aufbau von organischen Elektrolumineszenzvorrichtungen ist beispielsweise in US 4,539,507 und US 5,151,629 beschrieben. Üblicherweise besteht eine organische Elektrolumineszenzvorrichtung aus mehreren Schichten, die mittels Vakuummethoden oder unterschiedlichen Druckmethoden aufeinander aufgebracht werden. Diese Schichten sind im einzelnen:
1. Eine Trägerplatte = Substrat (üblicherweise Glas oder Kunststoffolie).
2. Eine transparente Anode (üblicherweise Indium-Zinn-Oxid, ITO).
3. Eine Lochinjektions-Schicht (Hole Injection Layer = HIL): z. B. auf der Basis von Kupfer-phthalocyanin (CuPc) oder leitfähigen Polymeren, wie Polyanilin (PANI) oder Polythiophen-Derivaten (wie PEDOT).
4. Eine oder mehrere Lochtransport-Schichten (Hole Transport Layer = HTL): üblicherweise auf der Basis von Triarylamin-Derivaten, z. B. 4,4',4"-Tris(N-1-naphthyl)N-phenyl-amino)-triphenylamin (NaphDATA) als erste Schicht und N,N'-Di(naphth-1-yl)-N,N'-diphenyl-benzidin (NPB) als zweite Lochtransportschicht.
5. Eine oder mehrere Emissions-Schichten (Emission Layer = EML): diese Schicht (bzw. Schichten) kann teilweise mit den Schichten 4 bis 8 zusammenfallen, besteht aber üblicherweise aus mit Phosphoreszenzfarbstoffen, z. B. Tris-(2-phenylpyridyl)-iridium (Ir(PPy)₃) oder Tris-(2-benzothienylpyridyl)-iridium (Ir(BTP)₃), dotierten Matrixmaterialien, wie 4,4'-Bis(carbazol-9-yl)-biphenyl (CBP); die Emissions-Schicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockier-Schicht (Hole-Blocking-Layer = HBL): diese Schicht kann teilweise mit den Schichten 7 und 8 zusammenfallen; sie besteht üblicherweise aus BCP (2,9-Dimethyl-4,7-diphenyl-1,10-phenanthrolin = Bathocuproin) oder Bis-(2-methyl-8-chinolinolato)-4-(phenylphenolato)-aluminium(III) (BAlq).
7. Eine Elektronentransport-Schicht (**E**lectron **T**ransport **L**ayer = ETL): üblicherweise auf Basis von Aluminium-tris-8-hydroxychinolinat (AlQ₃).
8. Eine Elektroneninjektions-Schicht (**E**lectron **I**njection **L**ayer = EIL): eine dünne Schicht bestehend aus einem Material mit einer hohen Dielektrizitätskonstanten, z. B. LiF, Li₂O, BaF₂, MgO, NaF.
9. Eine Kathode: hier werden in der Regel Metalle, Metallkombinationen oder Metallegierungen mit niedriger Austrittsarbeit verwendet, z. B. Ca, Ba, Cs, Mg, Al, In oder Mg/Ag.

Allerdings gibt es bei OLEDs, die Triplettemission zeigen, immer noch erhebliche Probleme, die einer dringenden Verbesserung bedürfen. Dies gilt insbesondere auch für den Triplettemitter selbst.
In der Literatur wurden in jüngster Zeit Emitter auf der Basis von Metallkomplexen beschrieben (z. B. US 2003/0068526, WO 2003/000661, EP 1211257), die an Iridium koordinierte 1-Phenylisochinolin-Liganden als Teilstrukturen gemäß Formel A und Formel B enthalten. Dabei unterscheiden sich die gezeigten Teilstrukturen durch die Abwesenheit (Formel A) bzw. Anwesenheit (Formel B) einer Brücke zwischen dem Phenyl- und dem Isochinolin-Ring. Die Brücke enthält dabei 2-20 Alkylbrückenkohlenstoffatome, die gegebenenfalls durch Heteroatome ersetzt sein können.

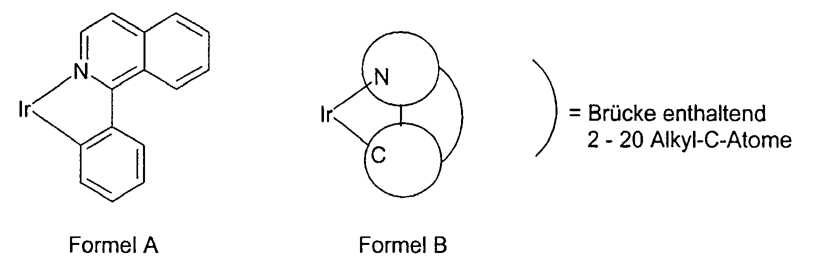

Verbindungen diesen Typs weisen in der Praxis einige Schwachpunkte auf, welche den technischen Einsatz dieser Verbindungen als unwahrscheinlich erscheinen lassen:
1. Sie besitzen häufig nur eine geringe Löslichkeit in organischen Lösungsmitteln, was eine effiziente Reinigung durch Umkristallisation oder Chromatographie stark erschwert oder gar verhindert. Dies gilt insbesondere für die Reinigung größerer Mengen, wie sie in der Displayfertigung benötigt werden.
2. Sie sind - vor allem in Lösung - sehr oxidationsempfindlich. Gegebenenfalls muß die Reinigung, die Lagerung, der Transport und die Verarbeitung dieser Verbindungen unter Inertgas erfolgen.
3. Ein weiterer entscheidender Mangel ist die geringe thermische Stabilität der oben beschriebenen Verbindungen. So kann zum Beispiel der homoleptische Komplex *fac-*Tris(1-phenyl-isochinolin-C²,N)iridium(III) - in der einschlägigen Literatur allgemein Ir(piq)₃ genannt - nicht unzersetzt sublimiert werden. Selbst unter typischen Hochvakuumbedingungen (p < 10⁻⁷ mbar) beobachtet man eine erhebliche Zersetzung dieser Verbindung, wobei neben einer iridiumhaltigen Asche, die ca. 30 Gew.% der eingesetzten Menge an *fac-*Tris(1-phenylisochinolin-C²,N)iridium(III) ausmacht, die Freisetzung von 1-Phenylisochinolin, neben anderen niedermolekularen Verbindungen, nachgewiesen werden kann. Diese thermische Zersetzung führt zu einer wenig reproduzierbaren Device-Charakteristik, wobei die Lebensdauer besonders negativ betroffen wird.

Überraschend wurde nun gefunden, daß Verbindungen, die eine Verknüpfung des Phenylrings mit dem Isochinolinring über eine einatomige Brücke aufweisen, ausgezeichnete Eigenschaften als Triplettemitter in OLEDs besitzen.
1. Die erfindungsgemäßen Verbindungen zeichnen sich durch eine gute Löslichkeit in organischen Lösungsmitteln aus, was ihre Reinigung durch gängige Verfahren wie Umkristallisation oder Chromatographie erheblich erleichtert. Damit sind die Verbindungen auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Schattenmasken erheblich erleichtert wird.
2. Die erfindungsgemäßen Verbindungen zeichnen sich durch eine verbesserte Oxidationsstabilität aus, was sich positiv auf die Reinigung und generell auf die Handhabung dieser Verbindungen auswirkt. Zusätzlich kann dies bei Verwendung in entsprechenden erfindungsgemäßen Vorrichtungen zu einer deutlichen Erhöhung der operativen Lebensdauer führen.
3. Die erfindungsgemäßen Verbindungen zeichnen sich auch durch eine hohe Temperaturstabilität aus, so daß sie in der Regel im Hochvakuum unzersetzt verdampft werden können. Diese Eigenschaft ist eine Grundvoraussetzung zur reproduzierbaren Darstellung von OLEDs und wirkt sich insbesondere positiv auf die operative Lebensdauer aus. Weiterhin ist so die ressourcenschonende Nutzung von Verbindungen dieser seltenen Metalle möglich.
4. Die erfindungsgemäßen Verbindungen sind gut reproduzierbar in verläßlicher, hoher Reinheit herstellbar und weisen keine Chargenschwankung auf. Ein industrieller Prozeß zur Herstellung der erfindungsgemäßen Elektrolumineszenzvorrichtungen ist daher wesentlich effizienter.

Gegenstand der vorliegenden Erfindung sind die Verbindungen gemäß Formel (1)

M(L)ₙ(L')ₘ(L")ₒ Formel (1)

enthaltend eine Teilstruktur M(L)ₙ der Formel (2a), 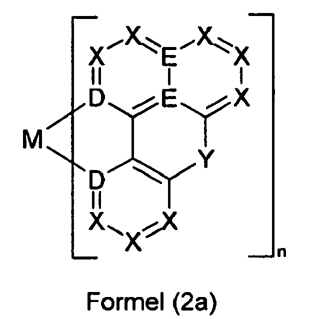 wobei für die verwendeten Symbole und Indizes gilt:
- M: ist bei jedem Auftreten Ir oder Pt;
- Y: ist gleich oder verschieden bei jedem Auftreten BR¹, CR₂, C=O, C=CR₂, SiR¹₂, NR¹, PR¹, P(O)R¹, O oder eine Einfachbindung;
- D: ist gleich oder verschieden bei jedem Auftreten ein Kohlenstoffatom oder ein Stickstoffatom, mit der Maßgabe, daß ein D für ein Kohlenstoffatom steht und das andere D für ein Stickstoffatom;
- X: ist gleich oder verschieden bei jedem Auftreten CR, N oder P; oder eine oder mehrere Einheiten X-X (also zwei benachbarte X) steht für NR, S oder O; oder eine Einheit X-X (also zwei benachbarte X) in den kondensierten Teilcyclen Cy2 und Cy3 steht für CR, N oder P, falls eines der Symbole E für N steht;
- E: ist gleich oder verschieden bei jedem Auftreten C oder N mit der Maßgabe, daß mindestens ein Symbol E für C steht und weiterhin mit der Maßgabe, daß genau eine Einheit X-X in den kondensierten Teilcyclen, welche das Symbol E enthalten, gleich CR ist, falls ein Symbol E für N steht;
- R: ist gleich oder verschieden bei jedem Auftreten H, F, Cl, Br, I, OH, NO₂, CN, eine geradkettige, verzweigte oder cyclische Alkyl- oder Alkoxygruppe mit 1 bis 20 C-Atomen, wobei eine oder mehrere nicht benachbarte CH₂-Gruppen durch -R¹C=CR¹- -C≡C-, Si(R¹)₂, Ge(R¹)₂, Sn(R¹)₂, -O-, -S-, -NR¹-, -(C=O)-, - (C=NR¹)-, -P=O(R¹)- oder -CONR¹- ersetzt sein können und wobei ein oder mehrere H-Atome durch F ersetzt sein können, oder eine Aryl-, Heteroaryl-, Aryloxy- oder Hetraryloxygruppe mit 1 bis 14 C-Atomen, die durch einen oder mehrere nicht-aromatische Reste R substituiert sein kann, wobei mehrere Substituenten R, sowohl am selben Ring als auch an unterschiedlichen Ringen zusammen, wiederum ein weiteres mono- oder polycyclisches, aliphatisches oder aromatisches Ringsystem aufspannen können;
- R¹: ist gleich oder verschieden bei jedem Auftreten H oder ein aliphatischer oder aromatischer Kohlenwasserstoffrest mit 1 bis 20 C-Atomen;
- n: ist 1, 2 oder 3;
dabei sind die Liganden L' und L" in Formel (1) monoanionische, zweizähnig chelatisierende Liganden und m und o sind gleich oder verschieden bei jedem Auftreten 0, 1 oder 2.

Eine bevorzugte Ausführungsform der vorliegenden Erfindung sind die Verbindungen der Formel (1a),

M(L)ₙ(L')ₘ(L")ₒ Formel (1a)

enthaltend mindestens eine Teilstruktur M(L)ₙ der Formel (2b), gleich oder verschieden bei jedem Auftreten, 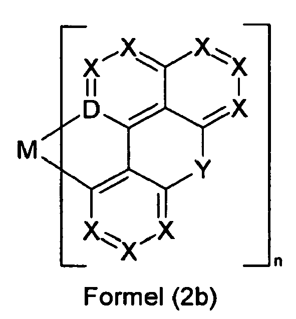 und gegebenenfalls enthaltend eine Teilstruktur M(L')ₘ der Formel (3), gleich oder verschieden bei jedem Auftreten, 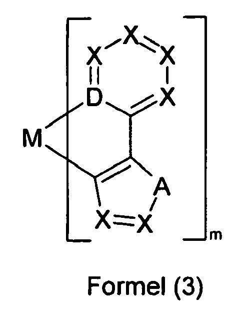 wobei M, X, Y, R, R¹, L", n, m und o dieselbe Bedeutung haben, wie oben beschrieben, und die weiteren Symbole und Indizes folgende Bedeutung haben:
- D: ist gleich oder verschieden bei jedem Auftreten N;
- A: ist gleich oder verschieden bei jedem Auftreten -CR=CR-, -N=CR-, -N=N-, NR, O, S, Se;

Erfindungsgemäße monoanionische, zweizähnige Liganden L" sind 1,3-Diketonate abgeleitet von 1,3-Diketonen, wie z. B. Acetylaceton, Benzoylaceton, 1,5-Diphenylacetylaceton, Bis(1,1,1-trifluoracetyl)methan, 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, N,N-Dimethylglycin, Alanin, N,N-Dimethylalanin, Salicyliminate abgeleitet von Salicyliminen, wie z. B. Methylsalicylimin, Ethylsalicylimin, Phenylsalicylimin, Borate Stickstoff-haltiger Heterocyclen, wie z. B. Tetrakis(1-imidazolyl)borat und Tetrakis(1-pyrazolyl)borat.

Bevorzugt sind ebenfalls die erfindungsgemäßen Verbindungen gemäß Formel (1) bzw. Formel (1a), bei denen für das Symbol n = 2 oder 3 gilt. Besonders bevorzugt sind Verbindungen, bei denen für das Symbol m = o = 0 gilt. Dabei gilt insbesondere, daß n = 2 und m = o = 0 für Platin-Komplexe und n = 3 und m = o = 0 für IridiumKomplexe bevorzugt ist.

Bevorzugt sind die erfindungsgemäßen Verbindungen gemäß Formel (1) bzw. Formel (1 a), bei denen für das Symbol X = CR gilt.

Bevorzugt sind die erfindungsgemäßen Verbindungen gemäß Formel (1) bzw. Formel (1a), bei denen für das Symbol Y = CR₂, C=O, C=CR₂, NR¹, PR¹, P(O)R¹, O oder eine Einfachbindung darstellt. Besonders bevorzugt steht das Symbol Y für CR₂.

Ebenfalls bevorzugt sind die erfindungsgemäßen Verbindungen gemäß Formel (1) bzw. Formel (1a), bei denen für das Symbol R gilt:
- R: ist gleich oder verschieden bei jedem Auftreten H, F, eine geradkettige, verzweigte oder cyclische Alkyl- oder Alkoxygruppe mit 1 bis 4 C-Atomen, wobei ein oder mehrere H-Atome durch F ersetzt sein können, oder eine Aryl- oder Heteroarylgruppe mit 1 bis 6 C-Atomen, die durch einen oder mehrere, nicht-aromatische Reste R substituiert sein kann, wobei mehrere Substituenten R, sowohl am selben Ring als auch unterschiedlichen Ringen zusammen wiederum ein weiteres aliphatisches oder aromatisches, mono- oder polycyclisches Ringsystem aufspannen können.

Auch wenn dies aus dem oben gesagten bereits hervorgeht, sei an dieser Stelle nochmals ausdrücklich darauf hingewiesen, daß für den Fall Y = CR₂ die beiden Substituenten R ein weiteres aliphatisches oder aromatisches, mono- bzw. polycyclisches Ringsystem aufspannen können. In diesem Fall wird das verbrückende C-Atom zum Spiro-C-Atom, das zwei Ringsysteme orthogonal miteinander verknüpft.

Dem oben gesagten entsprechend, sind ebenfalls bevorzugt Verbindungen gemäß Formel (1), enthaltend mindestens eine Teilstruktur M(L)ₙ der Formel (2a), gleich oder verschieden bei jedem Auftreten, dadurch gekennzeichnet, daß Y ein Spiro-C-Atom ist.

Aus den Strukturen für die oben beschriebenen erfindungsgemäßen Verbindungen gemäß Formel (1) geht hervor, daß die Teilstruktur M(L)ₙ der Formel (2a) planar gebaut ist, wobei die verbrückende Gruppe Y diese Planarität zwangsläufig, durch die starre Verknüpfung des Cyclus 1 mit den beiden kondensierten Teilcyclen Cy2/Cy3 (bzw. des Aryl- mit dem Isochinolinring), erzeugt. Diese Eigenschaft der erfindungsgemäßen Verbindungen steht im Kontrast zur Nichtplanarität der bisher in der Literatur beschriebenen Systeme gemäß Formel A und B. Hier verhindern entweder, wie bei den Verbindungen gemäß Formel A, die Wasserstoffatome an den Positionen 6 am Phenylring und 8 am Isochinolinring oder, wie bei Verbindungen gemäß Formel B, die Brücke, enthaltend 2 - 20 Alkylbrückenkohlenstoffatome, die Einebnung der verknüpften Arylteilringsysteme. Dieser fundamentale strukturelle Unterschied der oben genannten Substanzklassen zu den erfindungsgemäßen Verbindungen hat weitreichende Folgen für die Quanteneffizienz der Lumineszenz. Entsprechend dem in der optischen Spektroskopie von anellierten und kondensierten heteroaromatischen Systemen generell beobachteten Trend (N. Turro, University Science Books, 55D Gate Five Road, Sausalito, CA 94965, ISBN 0-935702-71-7), besitzen auch hier die steiferen, planaren Systeme die größeren Lumineszenzquantenausbeuten im Vergleich zu den flexibleren, nicht planaren Systemen gemäß Formel A und B. Größere Lumineszenzquantenausbeuten führen, wie zu erwarten, in der OLED zu deutlich verbesserten Effizienzen der erfindungsgemäßen Verbindungen gemäß Formel (1).

Gegenstand der vorliegenden Erfindung sind weiterhin die Verbindungen gemäß Formel (4a) 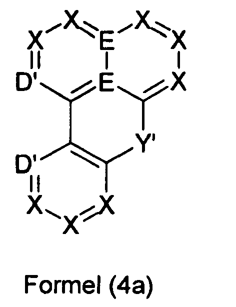 wobei die Symbole E und X dieselbe Bedeutung haben, wie oben beschrieben, und für die weiteren Symbole gilt:
- Y': ist gleich oder verschieden bei jedem Auftreten BR¹, CR₂, C=NR¹, C=CR₂, SiR¹₂, PR¹, P(O)R¹;
- D': ist gleich oder verschieden bei jedem Auftreten C-H oder N, mit der Maßgabe, daß ein Symbol D' für C-H steht und das andere Symbol D' für N steht.

Eine bevorzugte Ausführungsform der vorliegenden Erfindung sind die Verbindungen gemäß Formel (4b), 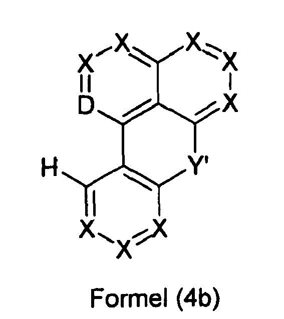 wobei D für N steht und die weiteren Symbole dieselbe Bedeutung haben, wie oben für Formel (2b) und (4a) beschrieben.

Bevorzugte Ausführungsformen der Verbindungen gemäß Formel (4a) bzw. (4b) sind analog den oben gemachten Ausführungen für die Teilstrukturen gemäß Formel (2a) bzw. (2b).

Diese Verbindungen stellen die Liganden L zu den oben genannten Verbindungen gemäß Formel (1) dar und sind somit nützliche Zwischenprodukte zur Synthese dieser Verbindungen.

Die erfindungsgemäßen Verbindungen gemäß Formel (4a) bzw. (4b) können nach gängigen organisch chemischen Verfahren dargestellt werden, was im folgenden exemplarisch beschrieben sei:

### 1) 7,7-Difluordibenzo[de,h]chinolin (s. auch Beispiel 1)

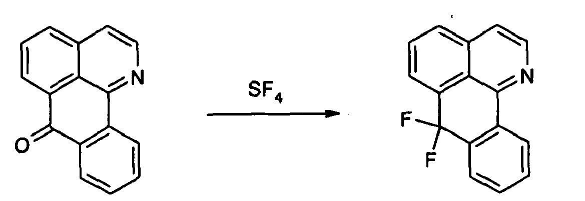

Die direkte Fluorierung von Azabenzanthron und analogen 7H-Dibenzo[de,h]chinolin-7-onen mit Schwefeltetrafluorid, gegebenenfalls in Anwesenheit einer Lewissäure, führt glatt und in guten Ausbeuten zu den 7,7-Difluoranaloga.

### 2) 7,7-Dimethyldibenzo[de,h]isochinolin (s. auch Beispiel 2)

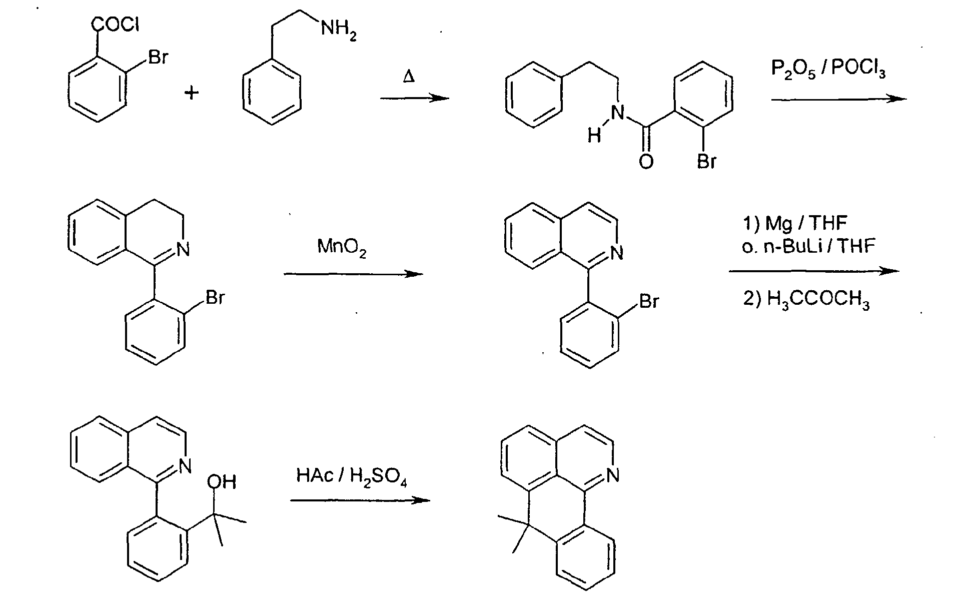

Auf dem oben gezeigten Weg sind symmetrisch 7,7-disubstituierte 7H-Dibenzo[de,h]chinoline in guten Ausbeuten zugänglich. Analog können durch Ersatz von Aceton in Schritt 4 durch andere Ketone leicht weitere Derivate erhalten werden. So führt die Verwendung des Ketons Pentan-3-on zu einem Ligandensystem, wie in Beispielstruktur 3 gezeigt, die von Benzophenon zu einem Ligandensystem, wie in Beispielstruktur 7 gezeigt. Die Verwendung von cyclischen Ketonen, wie z. B. von Cyclopentanon oder Fluorenon, führt zu den Ligandensystemen, wie in den Beispielstrukturen 6 und 8 gezeigt, also zu Ligandensystemen mit Spiro-C-Atom. Alternativ läßt sich statt des Ketons auch Chlorameisensäuremethylester einsetzen, der im Folgeschritt mit einem Organolithium-Reagens oder einer Grignard-Verbindung umgesetzt wird. Setzt man anstatt des 2-Brombenzoesäurechlorids andere funktionalisierte 2-Brombenzoesäurechloride ein, so können am Phenylring funktionalisierte 7,7-Dialkyl-7H-dibenzo[de,h]-isochinoline erhalten werden. So führt die Verwendung von 2-Bromnicotinsäurechlorid, 2-Bromisonicotinsäurechlorid, 2-Brom-4-fluorbenzoesäurechlorid, 2-Brom-3,4-dimethylbenzoesäurechlorid, 2-Brom-3-methyl-4-fluorbenzoesäurechlorid, 2-Brom-3-cyano-4-fluorbenzoesäurechlorid zu Ligandenystemen, wie sie in den Beispielstrukturen 13, 14, 16, 17, 18 und 19 dargestellt sind.

### 3) 7-Alkyl-/7-Aryl-7-alkoxydibenzo[de,h]chinoline

### 7-Alkyl-/7-Aryl-7-fluordibenzo[de,h]chinoline

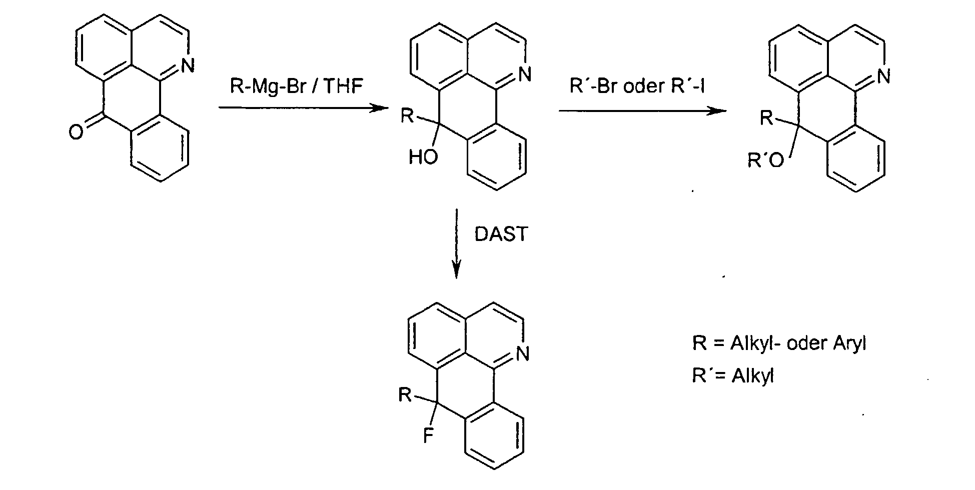

Die in 7-Position unsymmetrisch mit Alkyl bzw. Aryl und Alkoxy bzw. Fluor substituierten Verbindungen gemäß Formel (4a) bzw. (4b) können - wie oben gezeigt - durch konsekutive C-Alkylierung oder C-Arylierung der Carbonylfunktion des Azabenzanthrons mit Hilfe von Grignard- oder Organolithiumreagenzien oder anderen metallorganischen Reagenzien und anschließende Alkylierung oder Fluorierung (beispielsweise mit DAST = Diethylaminoschwefeltrifluorid) der Hydroxylgruppe erhalten werden. Diese Reaktionssequenz führt unter anderem zu Ligandensystemen, wie sie in den Beispielstrukturen 9, 10 und 12 gezeigt sind.

### 4) 7,7-Y'dibenzo[de,h]chinoline

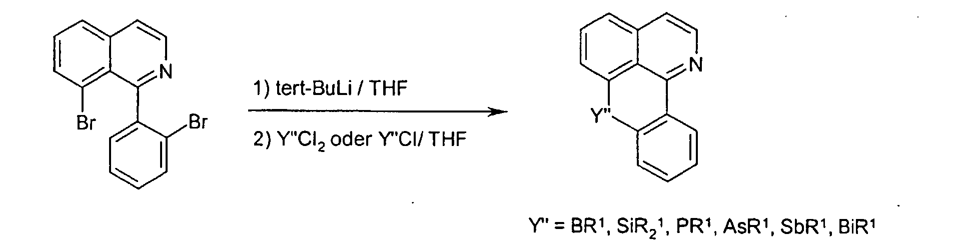

Setzt man in der oben beschriebenen Synthesesequenz 2) anstelle von 2-Phenylethylamin das 2-(3-Bromphenyl)ethylamin ein, so erhält man völlig analog das 1-(2-Bromphenyl)-8-bromisochinolin, welches nach zweifacher Lithiierung und anschließender Umsetzung mit den Elektrophilen Y"Cl₂ und Y"Cl zu Ligandensystemen, wie in den Beispielstrukturen 25, 26, 30 und 32 gezeigt, führt. Gegebenenfalls können diese, wie in den Fällen der Beispielstrukturen 30 und 32 durch Oxidation mit Luft oder Wasserstoffperoxid zu Ligandensystemen, wie in den Beispielstrukturen 31 und 33 gezeigt, weiter funktionalisiert werden.

Die erfindungsgemäßen Metallkomplexe sind prinzipiell durch verschiedene Verfahren darstellbar; es hat sich jedoch das im folgenden beschriebene Verfahren als besonders gut geeignet herausgestellt.

Daher ist ein weiterer Gegenstand der vorliegenden Erfindung ein Verfahren zur Herstellung der Metallkomplex-Verbindungen durch Umsetzung der Verbindungen gemäß Formel (4a) oder (4b) mit Metallalkoholaten der Formel (5), mit Metallketoketonaten der Formel (6) oder ein- oder mehrkernigen Metallhalogeniden der Formel (7), (8) oder (9), 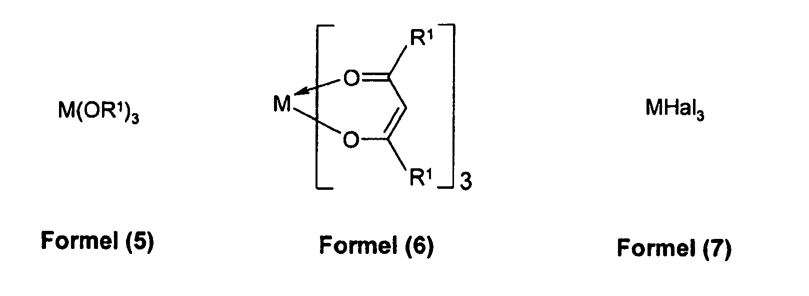 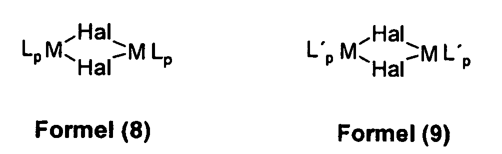 wobei die Symbole M und R¹ die oben angegebenen Bedeutungen haben, p = 1 oder 2 und Hal = F, Cl, Br oder I ist.

Gegebenenfalls können auch bevorzugt Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, wurden in DE 10314102.2 offenbart.

Die Synthese der Komplexe wird bevorzugt so durchgeführt, wie in WO 02/060910 und in DE 10314102.2 beschrieben.
Dabei fällt auf, daß sich die erfindungsgemäßen Metallkomplexe unter ansonsten gleichen Reaktionsbedingungen deutlich schneller bilden als die Metallkomplexe gemäß dem Stand der Technik. Deshalb liegt im erfindungsgemäßen Verfahren die Reaktionszeit, abweichend von den oben genannten Verfahren gemäß dem Stand der Technik, bevorzugt im Bereich von 1 bis 60 h, besonders bevorzugt im Bereich von 20 bis 50 h.

Durch dieses Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Mit den hier erläuterten Synthesemethoden lassen sich unter anderem die im folgenden dargestellten Beispielstrukturen 1 bis 95 für die Verbindungen gemäß Formel (1) herstellen.

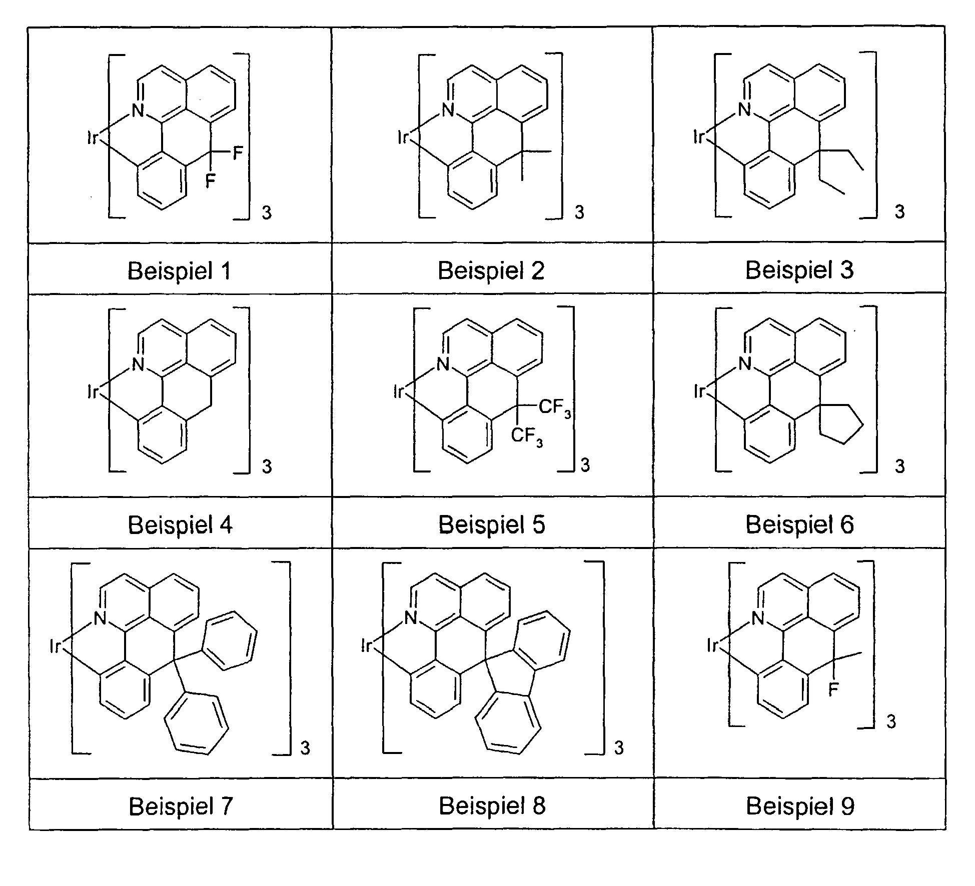

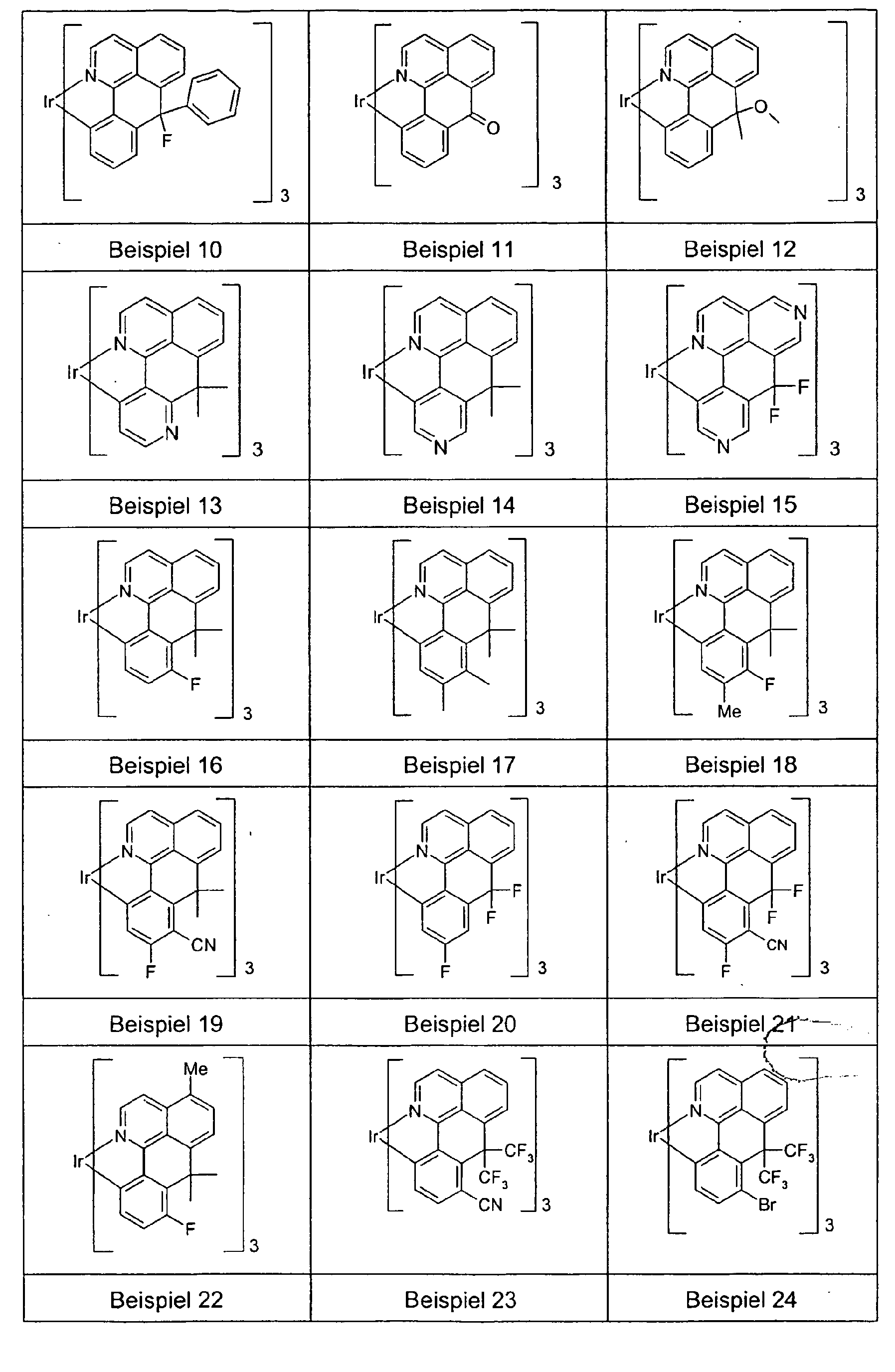

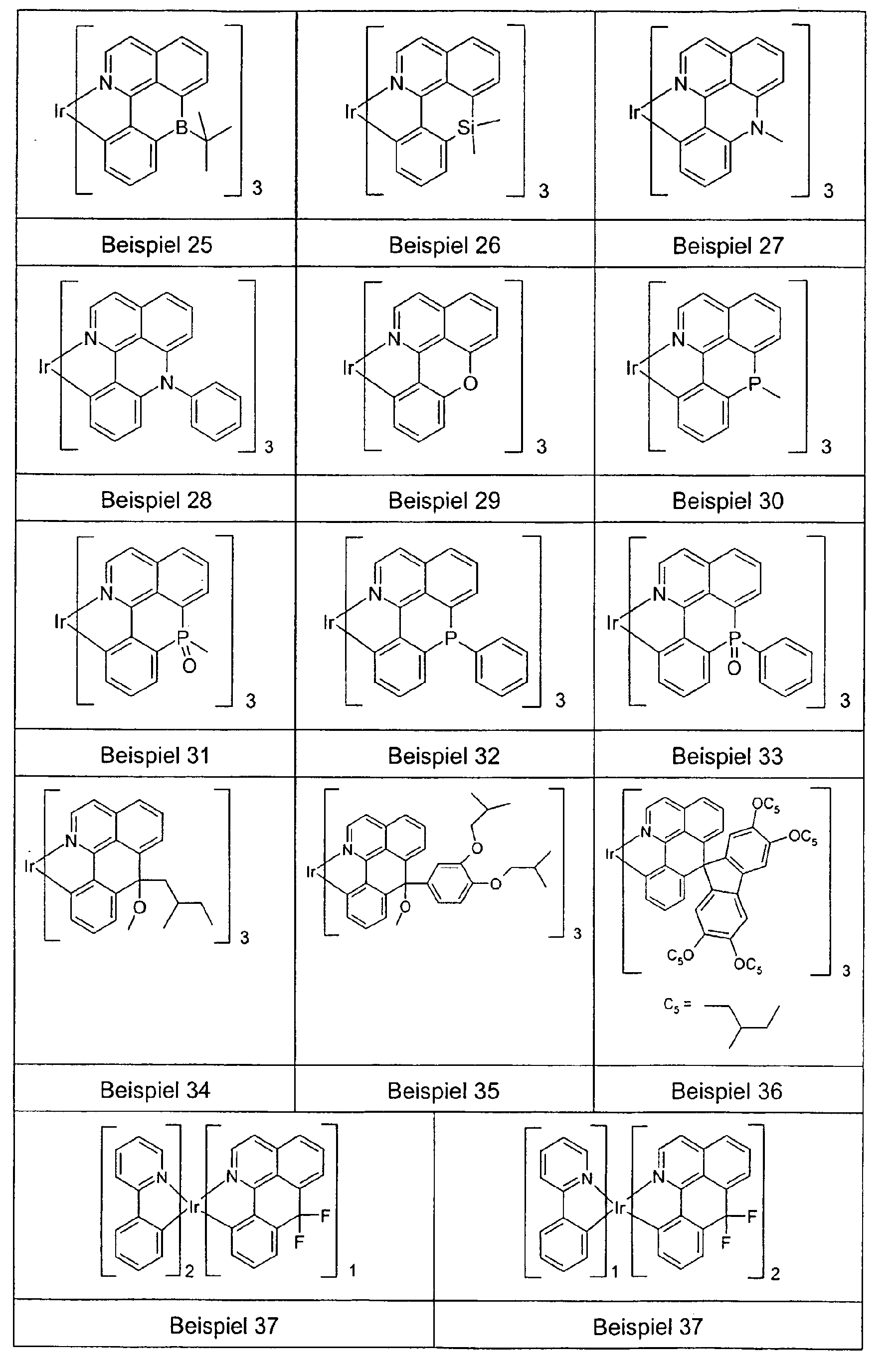

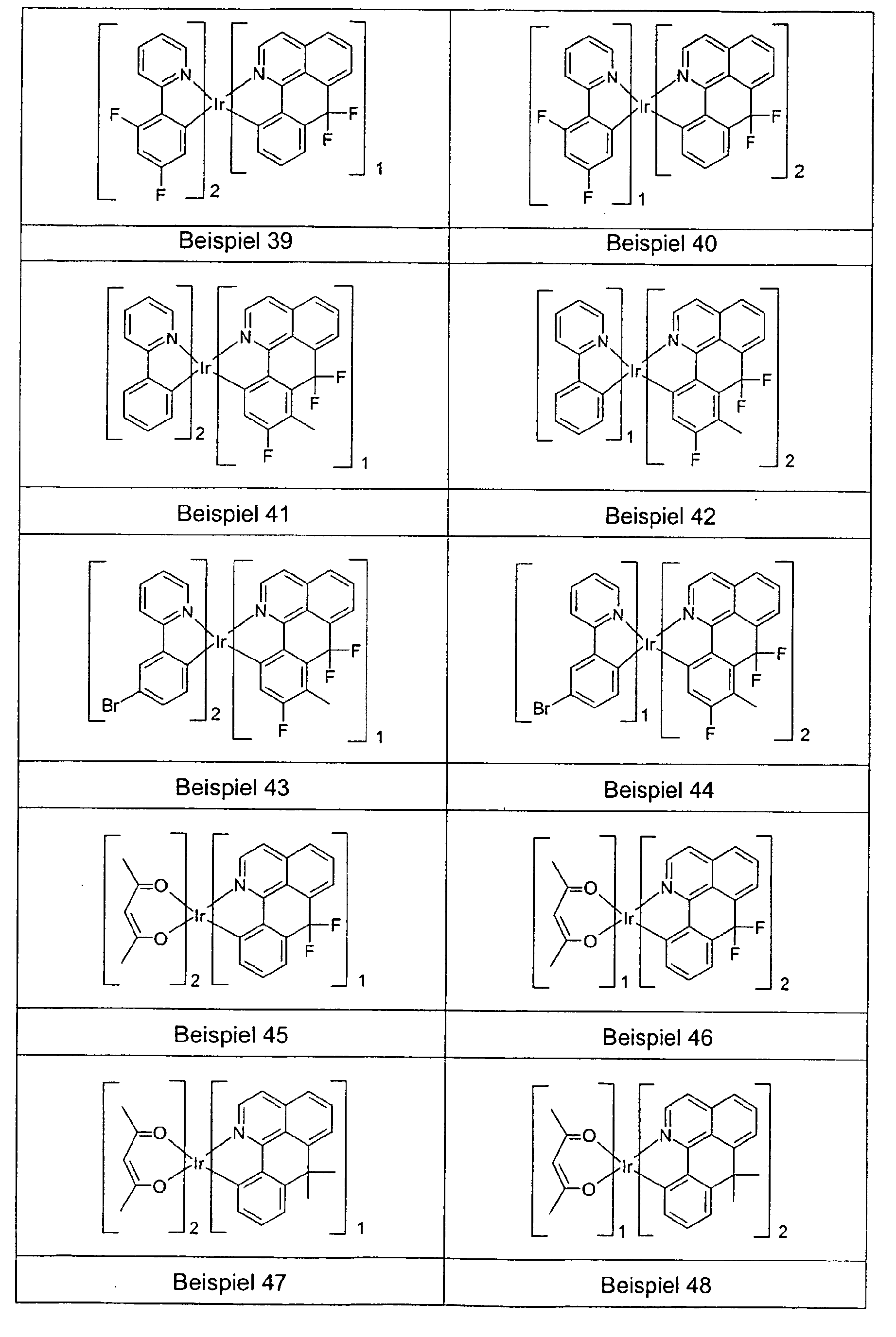

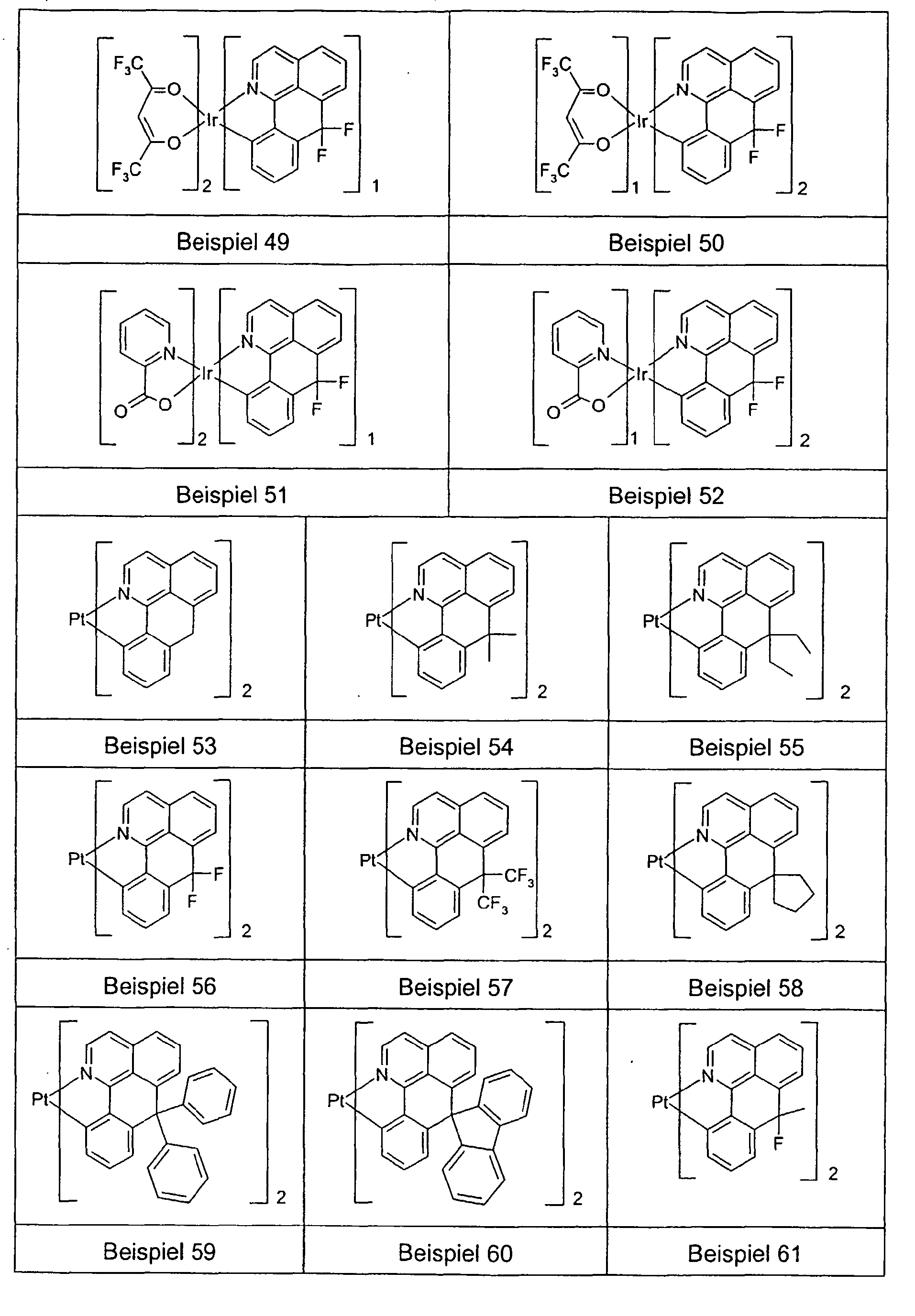

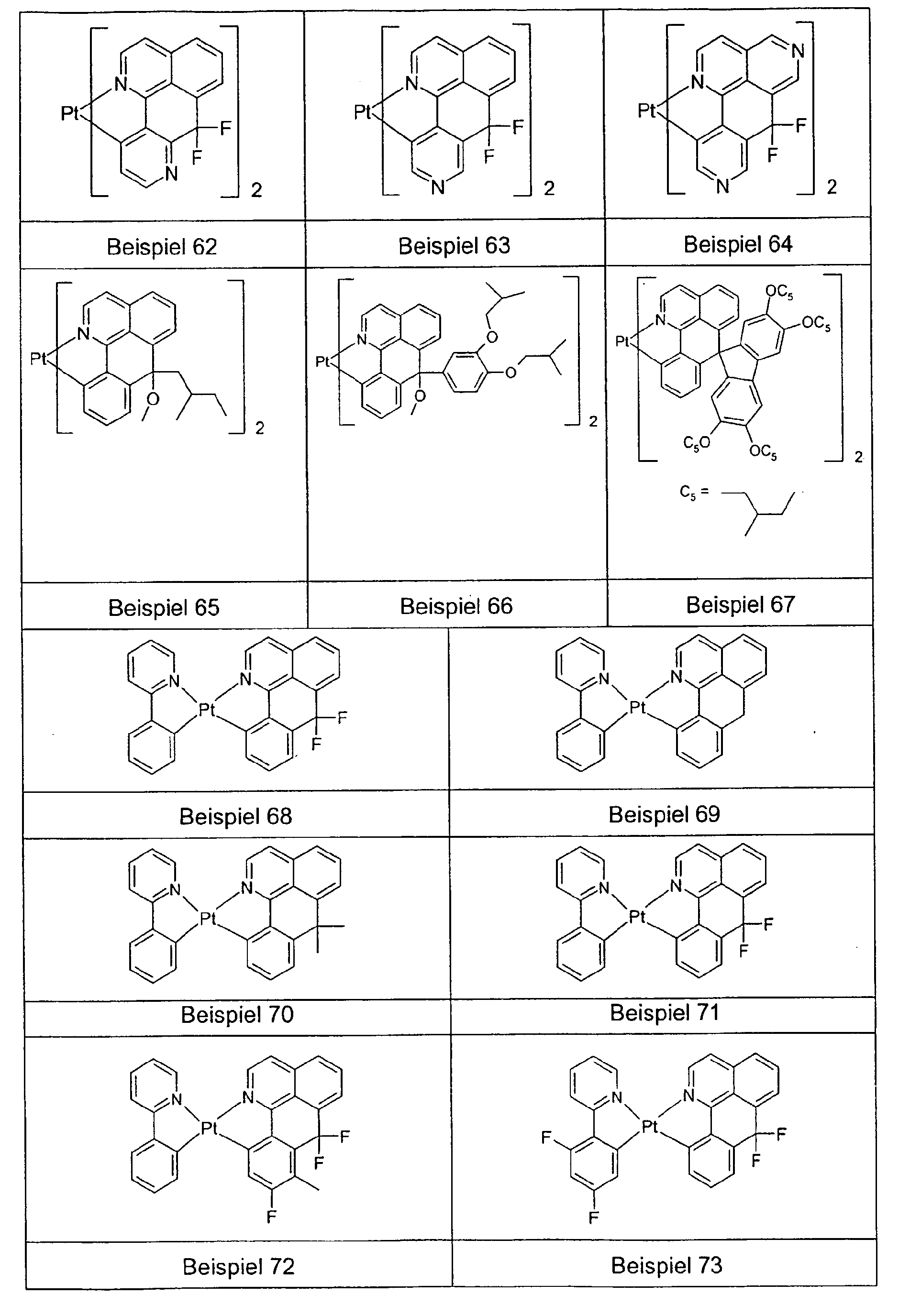

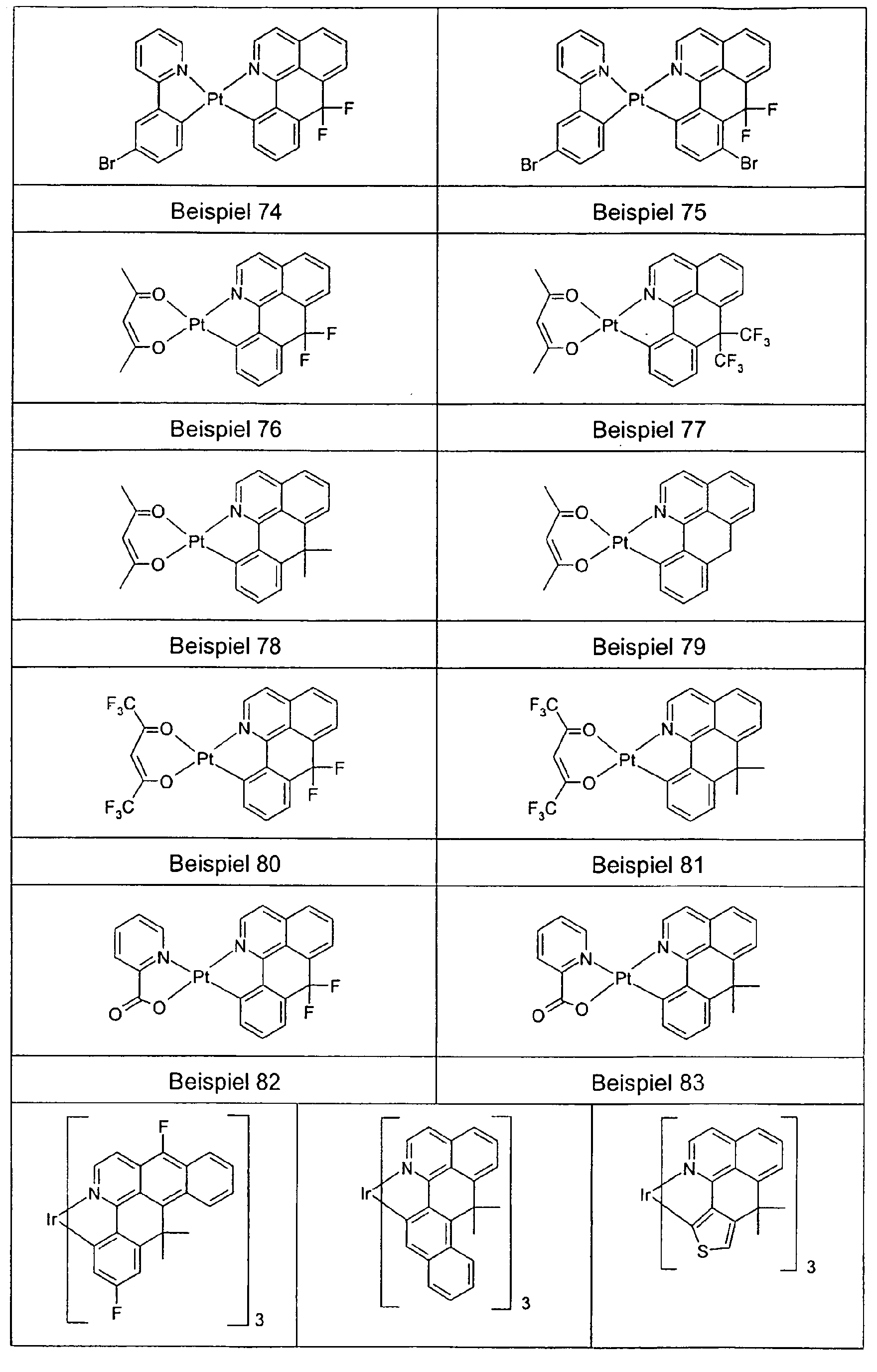

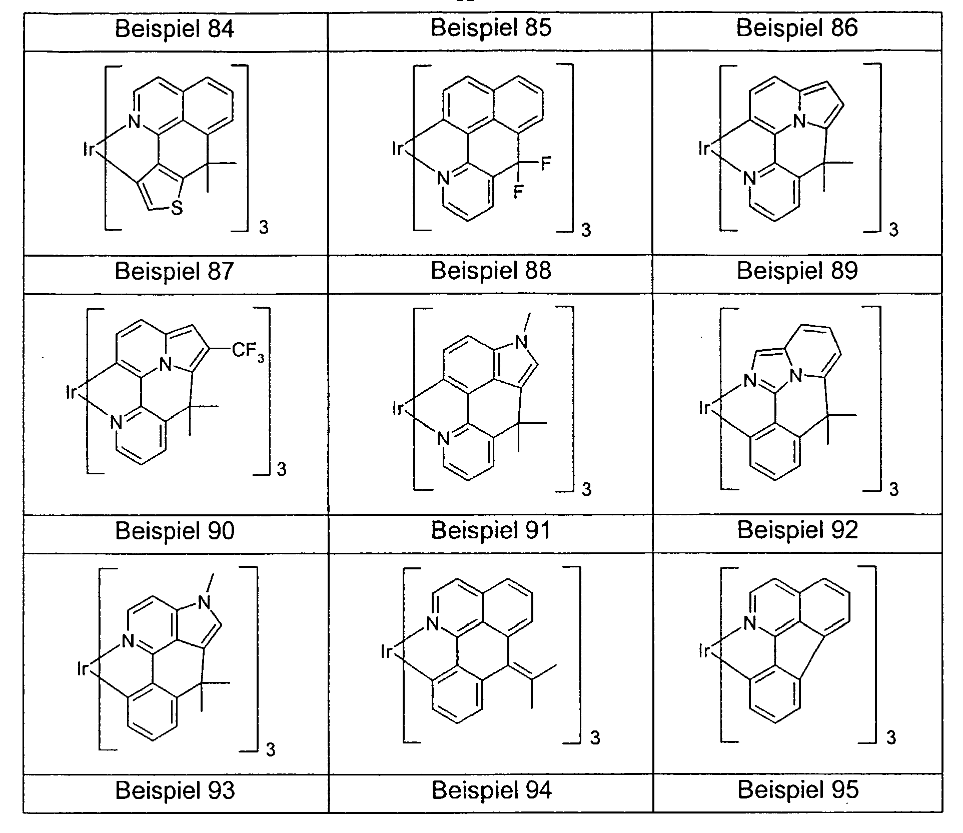

Die oben beschriebenen erfindungsgemäßen Verbindungen - z. B. Verbindungen gemäß den Beispielen 24, 43, 44, 74 und 75 - können auch als Comonomere und Bausteine zur Erzeugung entsprechender konjugierter, teilkonjugierter oder nichtkonjugierter Polymere oder Dendrimere Verwendung finden. Die entsprechende Polymerisation in die Hauptkette oder in die Seitenketten erfolgt dabei bevorzugt über die Brom-Funktionalität. So können sie u. a. in lösliche Polyfluorene (z. B. gemäß EP 842208 oder WO 00/22026), Poly-spirobifluorene (z. B. gemäß EP 707020 oder EP 894107), Poly-para-phenylene (z. B. gemäß WO 92/18552), Polycarbazole (z. B. gemäß DE 10304819.7 oder DE 10328627.6) oder auch Polythiophene (z. B. gemäß EP 1028136) einpolymerisiert werden oder auch in Copolymere, die mehrere verschiedene dieser Einheiten enthalten.

Weiterer Gegenstand der Erfindung sind somit konjugierte, teilkonjugierte oder nicht-konjugierte Polymere oder Dendrimere, enthaltend eine oder mehrere der Verbindungen gemäß Formel (1), wobei das oben definierte R eine Bindung zum Polymer oder Dendrimer darstellt.

Die oben genannten Polymere, Copolymere und Dendrimere zeichnen sich durch ihre gute Löslichkeit in organischen Lösungsmitteln aus.

Weiterhin können die erfindungsgemäßen Verbindungen gemäß Formel (1) natürlich auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß SUZUKI oder mit Aminen gemäß HARTWIG-BUCHWALD zu nennen.

Die erfindungsgemäßen Verbindungen, Polymere, Dendrimere oder erweiterten Verbindungen gemäß Formel (1) finden Verwendung als aktive Komponenten in elektronischen Bauteilen, wie z. B. organischen Leuchtdioden (OLEDs), organischen integrierten Schaltungen (O-ICs), organischen Feld-Effekt-Transistoren (O-FETs), organischen Dünnfilmtransistoren (O-TFTs), organischen Solarzellen (O-SCs) oder auch organischen Laserdioden (O-Laser).

Gegenstand der vorliegenden Erfindung ist also weiterhin die Verwendung der erfindungsgemäßen Verbindungen gemäß Formel (1), der erfindungsgemäßen Polymere und Dendrimere und entsprechender erweiterter Verbindungen gemäß Formel (1) als aktive Komponente in elektronischen Bauteilen.

Weiterer Gegenstand der Erfindung sind elektronische Bauteile, insbesondere organische Leuchtdioden (OLEDs), organische integrierte Schaltungen (O-ICs), organische Feld-Effekt-Transistoren (O-FETs), organische Dünnfilmtransistoren (O-TFTs), organische Solarzelle (O-SCs) oder auch organische Laserdioden (O-Laser), enthaltend eine oder mehrere erfindungsgemäße Verbindungen gemäß Formel (1), erfindungsgemäße Polymere und Dendrimere und entsprechende erweiterte Verbindungen gemäß Formel (1).

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Verbindungen herstellen bzw. das erfindungsgemäße Verfahren anwenden.

### Beispiele:

Die nachfolgenden Synthesen wurden, sofern nicht anders angegeben, unter einer Schutzgasatmosphäre in getrockneten Lösemitteln durchgeführt. Die Edukte wurden von ALDRICH [2-Brombenzoesäurechlorid, 3-Fluor-4-methylbenzolboronsäure, Mangandioxid, Magnesium] und von Fluka [Schwefeltetrafluorid] bezogen. 1-Azabenzanthron (7H-Dibenzo[de,h]chinolin-7-on) wurde nach der "Deutschen Reichs Patentschrift Nr.: 614196" dargestellt.

### Beispiel 1: Synthese von fac-Tris[7,7-difluor-7H-dibenzo[de,h]chinolin-C² N]iridium(III) (Ir1)

### A: 7,7-Difluordibenzo[de,h]chinolin

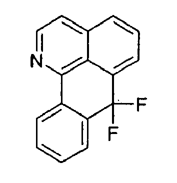

23.1 g (100 mmol) 1-Azabenzanthron wurden in einem inertisierten Bombenrohr vorgelegt. Anschließend wurden 22.7 g (210 mmol) Schwefeltetrafluorid einkondensiert. Diese Reaktionsmischung wurde 10 h auf 180°C erhitzt. Nach Erkalten des Bombenrohrs und Abblasen des überschüssigen Schwefeltetrafluorids wurde der braune Rückstand zweimal aus Dioxan / Ethanol (4 : 1) umkristallisiert. Die Ausbeute bei einer Reinheit von ca. 99.0 % betrug 18.3 g (72.3 mmol), 72.3 % d.Th..
¹H-NMR (CDCl₃): [ppm] = 8.86 (m, 1H), 8.73 (m, 1H), 8.62 (m, 1H), 8.40 (m, 1H), 8.09 (m, 1H), 7.88 (m, 1H), 7.76 (m, 1H), 7.70 (m, 1H), 7.60 (m, 1H).

### B: fac-Tris[7,7-difluordibenzo[de,h]chinolin-C²,N]iridium(III) (Ir1)

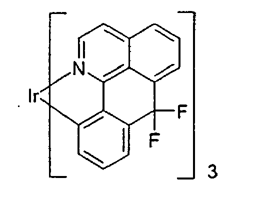

Ein Gemisch aus 15.20 g (60 mmol) 7,7-Difluor-7H-dibenzo[de,h]chinolin und 4.90 g (10 mmol) Iridium(III)acetylacetonat, suspendiert in 200 ml Ethylenglykol, wurde 140 h bei 165°C gerührt. Nach Erkalten auf Raumtemperatur wurde ein Gemisch aus 160 ml Ethanol und 40 ml 1N HCl zugetropft. Nach 20 min. Rühren wurde der tiefrote, feinkristalline Niederschlag abgesaugt, viermal mit 50 ml eines Gemischs aus Ethanol / 1N HCl (4 : 1), viermal mit 50 ml eines Gemischs aus Ethanol /Wasser (4 : 1) und viermal mit Ethanol gewaschen und anschließend im Vakuum getrocknet. Nach Hochvakuumsublimation (p = 10⁻⁵ mbar, T = 385°C) betrug die Ausbeute bei einer Reinheit von ca. 99.8 % 7.80 g (8.2 mmol), 82.2 % d.Th..
MS (FAB, m/z): M⁺ = 949.7.

### Beispiel 2: Synthese von fac-Tris[7,7-dimethyldibenzo[de,h]chinolin-C²,N]iridium(III) (Ir2)

### A: N-Phenylethyl-2-brombenzamid

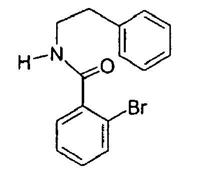

Eine Mischung von 62.7 ml (500 mmol) Phenylethylamin, 70.4 ml (506 mmol) Triethylamin und 150 ml Dichlormethan wurde bei 0 °C mit einer Lösung von 109.2 g 2-Brombenzoesäurechlorid in 50 ml Dichlormethan unter gutem Rühren tropfenweise so versetzt, daß die Temperatur 30 °C nicht überstieg. Anschließend wurde 1 h bei Raumtemperatur nachgerührt. Der so erhaltene farblose Feststoff wurde abgesaugt, dreimal mit 200 ml Dichlormethan gewaschen und im Vakuum getrocknet. Die Ausbeute bei einer Reinheit von ca. 99.0 % betrug 138.2 g (453 mmol), 90.7 % d.Th..
¹H-NMR (CDCl₃): [ppm] = 7.55 (m, 1H), 7.44 (m, 1H), 7.34-7.28 (m, 4H), 7.28-7.21 (m, 3H), 6.18 (br. t, NH, 1H), 3.73 (dt, NCH₂CH₂, 2H), 2.95 (t, NCH₂CH₂, 2H).

### B: 1-(2-Bromphenyl)-3,4-dihydroisochinolin

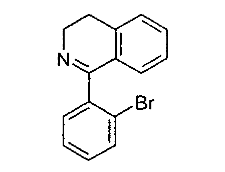

Eine Suspension von 50.0 g (164 mmol) N-Phenylethyl-2-brombenzamid und 27.9 g Phosphorpentoxid in 200 ml Xylol wurde auf 100°C erhitzt und tropfenweise mit 45.6 g (492 mmol) Phosphoroxychlorid versetzt. Anschließend wurde die Reaktionsmischung 2 h unter Rückfluß erhitzt. Nach Abkühlen auf 80 °C wurde die Reaktionsmischung in 4000 g Eis eingerührt und mit NaOH (fest) auf pH = 12 eingestellt. Die organische Phase wurde abgetrennt, die wäßrige Phase wurde dreimal mit 300 ml Toluol extrahiert, die vereinigten organischen Phasen wurden mit 500 ml Wasser gewaschen und anschließend über Magnesiumsulfat getrocknet. Nach Abfiltrieren des Trockenmittels und Entfernen des Lösemittels wurde das Produkt als gelbes Öl erhalten. Die Ausbeute bei einer Reinheit von ca. 99.0 % betrug 46.9 g (164 mmol), 99.9 % d.Th..
¹H-NMR (CDCl₃): [ppm] = 7.61 (m, 1H), 7.41 (m, 2H), 7.38-7.34 (m, 1H), 7.30-7.24 (m, 2H), 7.19-7.16 (m, 1H), 6.89 (m, 1H), 4.10 (br. m, 1H), 3.73 (br. m, 1H), 2.88 (br. m, 2H).

### C: 1-(2-Bromphenyl)isochinolin

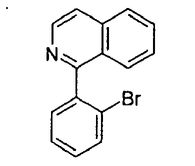

Ein Gemisch aus 28.6 g (100 mmol) 1-(2-Bromphenyl)-3,4-dihydroisochinolin, 86.9 g (1 mol) Mangandioxid und 200 ml 1,2-Dichlorbenzol wurde 5 h bei 180°C gerührt. Nach Erkalten wurde die Mischung mit 500 ml Toluol verdünnt und über Kieselgel filtriert. Nach Entfernen des Lösungsmittels wurde das Produkt als gelbes Öl erhalten. Die Ausbeute bei einer Reinheit von ca. 99.0 % betrug 26.0 g (91 mmol), 91.4 % d.Th..
¹H-NMR (CDCl₃): [ppm] = 8.63 (m, 1H), 7.86 (m, 1H), 7.73-7.61 (m, 4H), 7.51-7.42 (m, 3H), 7.37-7.33 (m, 1H).

### D: 1-(2-(2-Hydroxy-iso-propyl)phenyl)isochinolin

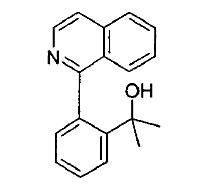

Eine Grignardverbindung, dargestellt aus 22.7 g (80 mmol)
1-(2-Bromphenyl)isochinolin und 2.1 g (85 mmol) Magnesium in 200 ml THF, wurde bei 0 °C tropfenweise mit einem Gemisch aus 8.8 ml (120 mmol) Aceton und 100 ml THF versetzt. Nach Erwärmen auf Raumtemperatur wurde die Reaktionsmischung 3 h unter Rückfluß erhitzt. Nach Erkalten wurden 800 ml Ethylacetat und 500 ml Wasser zugegeben, die organische Phase wurde abgetrennt und die wäßrige Phase wurde noch zweimal mit 200 ml Ethylacetat extrahiert. Die vereinigten organischen Phasen wurden mit gesättigter Natriumchloridlösung gewaschen und über Magnesiumsulfat getrocknet. Nach Entfernen des Lösemittels wurde das Produkt als gelbes Öl erhalten. Die Ausbeute bei einer Reinheit von ca. 99.0 % betrug 19.2 g (73 mmol), 91.2 % d.Th..
¹H-NMR (CDCl₃): [ppm] = 8.66 (m, 1H), 7.74 (m, 1H), 7.70-759 (m, 4H), 7.50-7.43 (m, 3H), 7.34-7.30 (m, 1H), 4.87 (br. s, 1H, OH), 2.15 (s, 6H, CH₃).

### E: 7,7-Dimethyldibenzo[de,h]chinolin

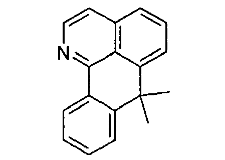

Eine Lösung von 13.2 g (50 mmol) 1-(2-(2-Hydroxy-*iso-*propyl)phenyl)isochinolin in 250 ml Essigsäure wurde mit 50 ml konz. Schwefelsäure versetzt und 16 h unter Rückfluß erhitzt. Nach Erkalten wurde die Reaktionsmischung auf 1000 g Eis gegossen, mit 5 N Natronlauge auf pH = 10 eingestellt und dreimal mit 300 ml Dichlormethan extrahiert. Die vereinigten organischen Phasen wurden mit Wasser gewaschen und über Magnesiumsulfat getrocknet. Nach Entfernen des Lösemittels und Umkristallisation aus Toluol/Ethanol (5 : 1) wurde das Produkt als gelber Feststoff erhalten. Die Ausbeute bei einer Reinheit von ca. 99.0 % betrug 8.4 g (34 mmol), 68.4 % d.Th..
¹H NMR (CDCl₃): [ppm] = 8.41 (m, 1H), 7.94 (m, 1H), 7.77-769 (m, 3H), 7.61 (m, 1H), 7.45-7.40 (m, 3H), 7.27-7.21 (m, 1H), 2.65 (s, 6H, CH₃).

### F: fac-Tris[7,7-dimethyldibenzo[de,h]chinolin-C²,N]iridium(III) (Ir2)

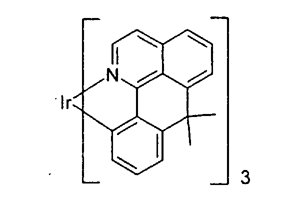

Ein Gemisch aus 14.72 g (60 mmol) 7,7-Dimethyl-7H-dibenzo[de,h]chinolin und 4.90 g (10 mmol) Iridium(III)acetylacetonat, suspendiert in 200 ml Ethylenglykol, wurde 140 h bei 165 °C gerührt. Nach Erkalten auf Raumtemperatur wurde ein Gemisch aus 160 ml Ethanol und 40 ml 1N HCl zugetropft. Nach 20 min. Rühren wurde der tiefrote, feinkristalline Niederschlag abgesaugt, viermal mit 50 ml eines Gemischs aus Ethanol / 1N HCl (4 : 1), viermal mit 50 ml eines Gemischs aus Ethanol / Wasser (4 : 1) und viermal mit Ethanol gewaschen und anschließend im Vakuum getrocknet. Nach Hochvakuumsublimation (p = 10⁻⁵ mbar, T = 385 °C) betrug die Ausbeute bei einer Reinheit von ca. 99.8 % 7.97 g (8.6 mmol), 86.1 % d.Th..
MS (FAB, m/z): M⁺ = 925.9.
¹H-NMR (CD₂Cl₂): [ppm] = 7.72 (d, *J* = 7.96 Hz, 1H), 7.69 (t, *J* = 8.03 Hz, 1H), 7.60 (d, *J* = 8.03 Hz, 1H), 7.48 (d, *J* = 6.36 Hz, 1H), 7.22 (d, *J* = 6.36 Hz, 1H), 7.03 (d, *J* = 6.36 Hz), 7.03 (d, *J* = 7.70 Hz, 1H), 6.88 (t, *J* = 7.7 Hz, 1H), 6.72 (d, *J* = 7.37 Hz, 1H), 1.69 (s, 3H, CH₃), 1.71 (s, 3H, CH₃).

### Beispiel 3: Synthese von fac-Tris[7,7-dimethyldibenzo-13-fluor[de,h]chinolin-C²,N]iridium(III) (Ir3)

### A: N-Phenylethyl-3-fluorbenzamid

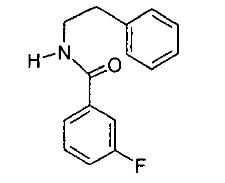

174.9 ml (1.39 mol) Phenylethylamin wurden in 600 ml Dichlormethan gelöst und mit 196.0 ml (1.41 mol, 1.01 Äq.) Triethylamin versetzt. Anschließend wurden 221.0 g (1.39 mol) 3-Fluorbenzoesäurechlorid bei 0 °C zu der Lösung zugetropft, so daß die Reaktionstemperatur nicht über 40 °C anstieg. Es wurde 18 h bei RT gerührt und der ausgefallene Feststoff in 1000 ml Dichlormethan gelöst. Man wusch viermal mit 200 ml verdünnter NaOH, 1 N HCl und gesättigter NaHCO₃-Lösung Die organische Phase wurde abgetrennt, über MgSO₄ getrocknet und unter Vakuum eingeengt. Der Feststoff wurde abgesaugt und zweimal mit wenig Dichlormethan gewaschen. Man erhielt 289.52 g eines weißen Feststoffs mit > 99 %iger Reinheit (gemäß HPLC), entsprechend 85.4% d. Th..
¹H-NMR (CDCl₃): [ppm] = 7.42 (dd, *J* = 7.03 Hz, 1.67 Hz, 1H), 7.3-7.39 (m, 3H), 7.24 (m_{c}, 3H), 7.17 (dt, *J* = 9.03 Hz, 1.68 Hz,1H), 6.1 (s_{br}, 1H, NH), 3.70 (t, *J* = 7.02 Hz, 2H, CH₂), 2.90 (t, *J* = 7.03 Hz, 2H, CH₂).

### B: 1-(3-Fluorphenyl)-3,4-dihydroisochinolin

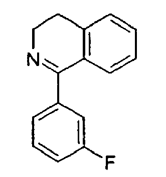

289.0 g (1.19 mol) N-Phenylethyl-3-fluorbenzamid wurden in 1000 ml Xylol gelöst und bei 90 °C portionsweise mit 202.7 g (1.43 mol, 1.2 Äq) Phosphorpentoxid versetzt. Anschließend wurden tropfenweise 326.8 ml (3.57 mol, 3.0 Äq) Phosphoroxychlorid zugegeben. Man erhitzte 4 h unter Rückfluß. Die Reaktionslösung wurde anschließend heiß auf Eis gegossen und unter Eiskühlung mit festem NaOH vorsichtig auf pH = 12 eingestellt. Der Niederschlag wurde dreimal mit 500 ml Toluol extrahiert, über MgSO₄ getrocknet und unter Vakuum zu einem stark viskosen, später kristallisierenden Öl eingeengt. Man erhielt 267.41 g mit einer Reinheit von ca. 99 %, entsprechend 99.8 % d. Th..
¹H-NMR (CDCl₃): [ppm] = 7.37 (m_{c}, 3H), 7.33 (dd, *J* = 9.3, 2.0 Hz, 1H), 7.26 (d, *J* = 7.8 Hz, 1H), 7.24 (d, *J* = 3.68 Hz, 2H), 7.12 (m_{c}, 1H), 3.84 (t, *J* = 7.36 Hz, 2H, CH₂), 2.79 (t, *J* = 7.36 Hz, 2H, CH₂).

### C: 1-(3-Fluorphenyl)isochinolin

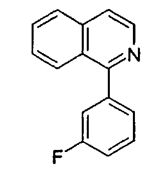

266.41 g (1.183 mol) 1-(3-Fluorphenyl)-3,4-dihydroisochinolin wurden in 1500 ml o-Dichlorbenzol gelöst und mit 901.2 g (10.37 mol, 8.7 Äq) Mangan versetzt. Es wurde 16 h bei 160-170°C gerührt. Anschließend wurde die Reaktionslösung über Celite filtriert und mit Dichlormethan/Ethanol (25 : 1) nachgespült. Anschließend wurde das Lösemittel im Vakuum abdestilliert. Man erhielt 264.74 g eines kristallinen Feststoffes mit 99 %iger Reinheit, entsprechend 99 % d. Th..
¹H-NMR (CDCl₃): [ppm] = 8.59 (d, *J* = 5.69 Hz, 1H), 8.05 (d, *J* = 8.36 Hz, 1H), 7.83 (d, *J* = 8.37 Hz, 1H), 7.65 (t, *J* = 8.03 Hz, 1H), 7.12 (d, *J* = 5.62 Hz, 1H), 7.46 (m_{c}. 2H), 7.42 (d, *J* = 8.7 Hz, 1H), 7.17 (m_{c}, 1H).

### D: 1-[3-Fluor-2-(carboxymethyl)phenyl]isochinolin

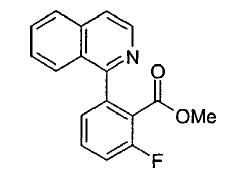

50.0 g (0.224 mol) 1-(3-Fluorphenyl)isochinolin wurden in 1000 ml THF gelöst und bei -78 °C tropfenweise mit 134.4 ml (0.336 mol, 1.50 Äq) n-Butyllithium (2.5 M in Hexan) versetzt. Nach beendeter Zugabe wurde noch 3 h bei -78 °C nachgerührt und anschließend bei -78 °C das rotbraune Lithiumorganyl zu einer Lösung aus 190.8 ml (2.47 mol, 11.0 Äq) Chlorameisensäuremethylester in 2000 ml THF umgeschlaucht. Es wurde bei -78°C bis auf -20 °C weitere 18 h gerührt. Die Reaktionslösung wurde unter externer Eiskühlung mit EtOH gequencht und auf ein Drittel des Volumens eingeengt. Anschließend wurde die Reaktionslösung mit 300 ml Dichlormethan versetzt und jeweils dreimal mit 100 ml NH₄Cl-Lösung und NaHCO₃-Lösung und Wasser gewaschen, über MgSO₄ getrocknet und unter Vakuum eingeengt. Das erhaltene stark viskose Öl wurde aus Heptan kristallisiert. Man erhielt 44.68 g eines kristallinen Feststoffs, entsprechend 70.4% d. Th., mit einer Reinheit von 98 %.
¹H-NMR (CDCl₃): [ppm] = 8.56 (d, *J* = 5.69 Hz, 1H), 7.89 (d, *J* = 8.36 Hz, 1H), 7.86 (d, *J* = 8.37 Hz, 1H), 7.69 (t, *J* = 8.03 Hz, 1H), 7.66 (d, *J* = 5.69 Hz, 1H), 7.55 (m_{c}, 2H), 7.37 (d, *J* = 7.7 Hz, 1H), 7.27 (t, *J* = 9.37 Hz, 1H), 3.46 (s, 3H, OMe).

### E: 1-[2-(1-Methyl-1-hydroxy-ethyl)-3-fluorphenyl]isochinolin

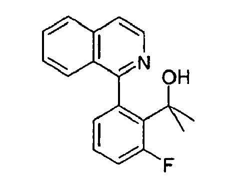

45.27 g (0.161 mol) 1-[3-Fluor-2-(carboxymethyl)phenyl]isochinolin wurden in 950 ml THF gelöst und bei -78 °C tropfenweise mit 185.12 ml (0.370 mol, 2.3 Äq.) Methyllithium (2 M in Diethylether) versetzt. Nach der Zugabe wurde 18 h bei -78 °C bis -20 °C gerührt. Die Reaktionslösung wurde anschließend unter Eiskühlung mit MeOH gequencht und mit 500 ml Dichlormethan versetzt. Es wurde dreimal mit 100 ml NaHCO₃-Lösun und Wasser gewaschen, über MgSO₄ getrocknet und unter Vakuum eingeengt. Der erhaltene Feststoff wurde aus 600 ml Heptan kristallisiert. Man erhielt 29.72 g eines weißen Feststoffes, entsprechend 65.8 % d. Th., mit einer Reinheit von 97.5 %.
¹H-NMR (DMSO-d6): [ppm] = 8.42 (d, *J* = 5.5 Hz, 1H), 7.84 (d, *J* = 8.25 Hz, 1H), 7.65 (t, *J* = 7.79 Hz), 7.62 (d(überlagert), *J* = 6.24 Hz, 1H), 7.60 (d (überlagert), *J* = 9.62 Hz, 1H), 7.48 (t, *J* = 7.33 Hz, 1H), 7.27 (m_{c},1H), 7.17 (dd, *J* = 12.38 Hz,
7.79 Hz), 6.96 (d, *J* = 7.79 Hz), 1.90 (s_{br}., 1H, OH), 1.67 (s, 3H, CH₃), 1.48 (s, 3H, CH₃).

### F: 7,7-Dimethyl-8-fluor-dibenzo[de,h]chinolin

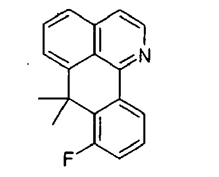

26.1 g (92.82 mmol) 1-[2-(1-Methyl-1-hydroxy-ethyl)-3-fluorphenyl]isochinolin wurden in ein 150°C heißes Gemisch aus 260 ml o-Dichlorbenzol und 104.2 ml H₂SO₄ gegeben und 60 min. gerührt. Die Reaktionslösung wurde anschließend auf 1000 ml Eis gegossen und unter Eiskühlung mit fester NaOH vorsichtig auf pH = 12 eingestellt. Anschließend wurde mit 500 ml Dichlormethan extrahiert, über MgSO₄ getrocknet und unter Vakuum eingeengt. Das Rohprodukt wurde in 100 ml Toluol gelöst und bei 50 °C 4 h Luft eingeleitet. Anschließend wurde säulenchromatographisch mit Dichlormethan aufgereinigt. Man erhielt 18.45 g eines Feststoffs, entsprechend 75.5% d. Th., mit einer Reinheit von 99.6 %.
¹H-NMR (CDCl₃): [ppm] = 8.74 (d, *J* = 8.03 Hz, 1H), 8.56 (d, *J* = 5.69 Hz, 1H), 7.66-7.77 (m, 3H), 7.57 (d, *J* = 5.69 Hz, 1H), 7.4 (m_{c}, 1H), 7.16 (dd, *J* = 12.71 Hz, 8.03 Hz), 1.86 (s, 6H, CH₃).

### G: fac-Tris[7,7-dimethyl-8-fluordibenzo[de,h]chinolin-C²,N]iridium(III) (Ir3)

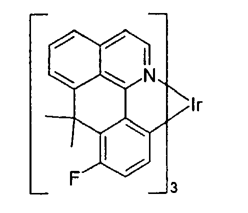

15.13 g (57.48 mmol, 5.93 Äq.) 7,7-Dimethyl-13-fluor-dibenzo[de,h]chinolin und 4.69 g (9.68 mmol) Na[Ir(acac)₂Cl₂] wurden in 180 ml entgastem Ethylenglykol (Spectranal) gelöst und unter Argonatmosphäre 48 h bei 198 °C gerührt. Die Reaktionslösung wurde anschließend auf 50 °C abgekühlt, in 350 ml eines entgasten, 50°C warmen Gemischs aus EtOH/1N HCl gegeben und 60 min. unter Luftausschluß gerührt. Der Feststoff wurde unter Luftausschluß abgesaugt, mit einem jeweils entgasten Gemisch aus EtOH/ 1N HCl (350 mL), EtOH /Wasser (1:1, 350 mL) und EtOH (350 mL) gewaschen und unter Vakuum getrocknet. Man erhielt 8.45 g eines roten Feststoffs, der aus Toluol/Ethanol (16 : 1) umkristallisiert wurde. Es wurden 5.29 g eines roten Pulvers erhalten, entsprechend 56.4 % d. Th., mit einer Reinheit von 99.5 %.
¹H-NMR (CDCl₃): [ppm] = 7.96 (d, *J* = 7.69 Hz, 1H), 7.88 (t, *J* = 7.7 Hz, 1H), 7.82 (d, *J* = 7.7 Hz, 1H), 7.57 (d, *J* = 6.36 Hz, 1H), 7.43 (d, *J* = 6.36 Hz, 1H), 6.76 (dd, *J* = 14.05 Hz , 8.03 Hz, 1H), 6.57 (dd, *J* = 8.04 Hz, 5.36 Hz, 1H), 1.80 (s, 3H), 1.77 (s, 3H).

### Beispiel 4: Synthese von fac-Tris[7,7-dimethyl-8-fluor-4-methyldibenzo[de,h]chinolin-C²,N]iridium(III) (Ir4)

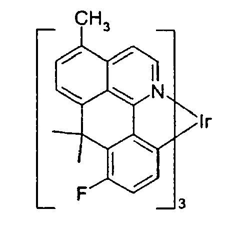

Die Synthese der Verbindung Ir4 wurde analog den Arbeitsvorschriften 3A bis 3G durchgeführt und mit vergleichbaren Ausbeuten und Reinheiten erhalten.
¹H-NMR (Pyridin-d5): [ppm] = 7.68 (d, *J* = 7.7 Hz, 1H), 7.58 (d, *J* = 6.69 Hz, 1H), 7.50 (d, *J* = 7.69 Hz, 1H), 7.39 (dd, *J* = 8.37 Hz, 5.96 Hz, 1H), 7.12 (d, *J* = 6.36 Hz, 1H), 6.97 (dd, *J* = 13.72 Hz, 8.36 Hz, 1H), 2.38 (s, 3H, CH₃), 1.95 (s, 3H, CH₃), 1.90 (s, 3H, CH₃).

### Beispiel 5: fac-Tris[7,7-dimethyl-8-fluor-4-methyldibenzo[de,h]chinolin-C²,N]iridium(III) (Ir5)

### A: 1-(3-Fluor-4-methylphenyl)isochinolin

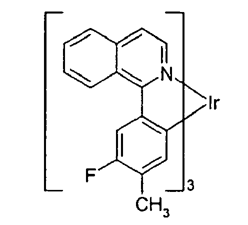

Es wurden 500 ml entgastes Dioxan vorgelegt und mit 10.0 g (61.14 mmol) 1-Chlorisochinolin, 18.8 g (122.0 mmol, 2.0 Äq.) 3-Fluor-4-methylbenzolboronsäure und 24.0 g (73.66 mmol, 1.2 Äq.) Cs₂CO₃versetzt. Die Reaktionsmischung wurde 10 min. entgast und mit 1.25 ml (5.49 mmol, 9 mol%) t-Bu₃P und 0.412 g (1.83 mmol, 3 mol%) Pd(OAc)₂ versetzt. Es wurde 18 h bei 105°C gerührt, anschließend mit 400 ml Dichlormethan versetzt und dreimal mit 200 mL NaHCO₃-Lösung und Wasser gewaschen. Anschließend wurde über Celite filtriert, über MgSO₄ getrocknet und unter Vakuum eingeengt. Das viskose Öl wurde an Kieselgel mit Ethylacetat/Heptan (1 : 5) gesäult. Man erhielt 10.47 g, entsprechend 72.2 % d. Th., mit einer Reinheit von 99.5 %.
¹H-NMR (CDCl₃): [ppm] = 8.60 (d, *J* = 5.69 Hz, 1H), 8.12 (d, *J* = 8.70 Hz, 1H), 7.89 (d, *J* = 8.37 Hz, 1H), 7.70 (t, *J* = 8.03 Hz, 1H) 7.65 (d, *J* = 5.69 Hz, 1H), 7.55 (t, *J* = 8.36 Hz, 1H), 7.39-7.35 (m, 2H), 7.34 (t, *J* = 8.03 Hz, 1H), 2.40 (s, 3H, CH₃).

### B: fac-Tris[7,7-dimethyl-8-fluor-4-methyldibenzo[de,h]chinolin-C²,N]iridium(III) (Ir5)

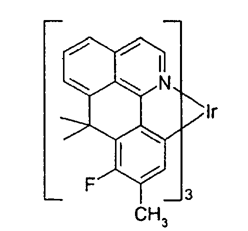

Die weitere Synthese von Ir5 erfolgte analog den Vorschriften 3D bis 3G. Die Produkte wurden mit vergleichbaren Ausbeuten und Reinheiten erhalten.
¹H-NMR (DMSO-d6): [ppm] = 7.73 (d, *J* = 4.86 Hz, 2H), 7.62 (t, *J* = 4.69 Hz, 1H), 7.40 (d, *J* = 6.36 Hz, 1H), 7.19 (d, *J* = 6.36 Hz, 1H), 6.52 (d, *J* = 7.69 Hz, 1H), 2.11 (s, 3H, CH₃), 1.89 (s, 3H, CH₃), 1.81 (s, 3H, CH₃).

### Beispiel 6: Vergleich der thermischen Stabilität mit Ir(piq)₃

Die Synthese von Ir(piq)₃ erfolgte gemäß US 2003/0068526. 2 g des dort beschriebenen Rohprodukt wurden im Hochvakuum (p = 10⁻⁷ mbar, T = 385 °C) sublimiert, wobei 607 mg einer iridiumhaltigen Asche, neben 1.38 g Sublimat, entsprechend Ir(piq)₃ mit einer Reinheit von 99.7 % nach HPLC erhalten, wurde. Dies zeigt also, daß sich bei der Sublimation bei gleicher Temperatur wie die erfindungsgemäßen Verbindungen etwa ein Drittel des Produkts zersetzt, während die erfindungsgemäßen Verbindungen praktisch verlustfrei sublimiert werden können, wie den Beispielen 1 und 2 entnommen werden kann.

### Beispiel 7: Herstellung und Charakterisierung von organischen Elektrolumineszenzvorrichtungen, die erfindungsgemäße Verbindungen Ir1 enthalten

Erfindungsgemäße Elektrolumineszenzvorrichtungen können, wie beispielsweise in der Patentanmeldung DE10330761.3 beschrieben, dargestellt werden.
Hier werden die Ergebnisse zweier verschiedener OLEDs gegenübergestellt. Der grundlegende Aufbau, die verwendeten Materialien, Dotierungsgrad und ihre Schichtdicken war zur besseren Vergleichbarkeit identisch. Es wurde ausschließlich der Dotand in der Emissionsschicht variiert.
Das erste Beispiel beschreibt einen Vergleichsstandard nach dem Stand der Technik, bei dem die Emitterschicht aus dem Wirtsmaterial CBP und dem Gastmaterial Ir(piq)₃ besteht. Des weiteren wird eine OLED mit einer Emitterschicht bestehend aus dem Wirtsmaterial CBP und dem Gastmaterial *fac-*Tris[7,7-difluor-dibenzo[de,h]chinolin-C²,N]iridium(III) (Ir1, synthetisiert nach Beispiel 1) beschrieben. Analog dem o. g. allgemeinen Verfahren, wurden OLEDs mit folgendem Aufbau erzeugt:

| | |
|---|---|
| PEDOT | 60 nm (aus Wasser aufgeschleudert; PEDOT bezogen von H. C. Starck, Goslar; Poly-[3,4-ethylendioxy-2,5-thiophen]), (HIL) |
| NaphDATA | 20 nm (aufgedampft; NaphDATA bezogen von SynTec; 4,4',4"-Tris(N-1-naphthyl)-N-phenyl-amino)-triphenylamin, (HTL) |
| S-TAD | 20 nm (aufgedampft; S-TAD synthetisiert nach WO 99/12888; 2,2',7,7'-Tetrakis(diphenylamino)-spirobifluoren), (HTL) |
| Emitter-Schicht: | (EML) |
| CPB | 20 nm (aufgedampft; CPB bezogen von ALDRICH und weiter gereinigt, schließlich noch zweimal sublimiert; 4,4'-Bis-(N-carbazolyl)biphenyl) |
| Ir1 | (20 % Dotierung, aufgedampft; synthetisiert nach Beispiel 1) |
| ODER: | |
| Ir(piq)₃ | (20 % Dotierung, aufgedampft; synthetisiert nach Beispiel 6) |
| BCP | 10 nm (aufgedampft; BCP bezogen von ABCR, verwendet wie erhalten; 2,9-Dimethyl-4,7-diphenyl-1,10-phenanthrolin), (HBL) |
| AlQ₃ | 10 nm (aufgedampft: AlQ₃ bezogen von SynTec; Tris(chinolinato)aluminium(III)), (ETL) |
| Ba-Al | 3 nm Ba, darauf 150 nm Al. |

Diese noch nicht optimierten OLEDs wurden standardmäßig charakterisiert; hierfür wurden die Elektrolumineszenzspektren, die Effizienz (gemessen in cd/A) in Abhängigkeit von der Helligkeit, berechnet aus Strom-Spannungs-Helligkeit-Kennlinien (IUL-Kennlinien), und die Lebensdauer bestimmt.

### Elektrolumineszenzspektren:

Die OLEDs, sowohl das Vergleichsbeispiel mit Ir(piq)₃ als auch die OLED mit Ir1 als Dotand zeigen eine rote Emission mit vergleichbaren Farbkoordinaten.

### Effizienz als Funktion der Helligkeit:

Mit OLEDs hergestellt mit dem Dotanden Ir(piq)₃ erhält man unter den oben beschriebenen Bedingungen typischerweise eine maximale Effizienz von etwa 6.5 cd/A und für die Referenzleuchtdichte von 100 cd/m² werden 6.2 V benötigt. Im Gegensatz dazu zeigen OLEDs hergestellt mit dem erfindungsgemäßen Dotanden **Ir1** eine maximale Effizienz von 8.7 cd/A, wobei die benötigte Spannung für die Referenzleuchtdichte von 100 cd/m² sogar auf 5.4 V sinkt.

### Lebensdauervergleich:

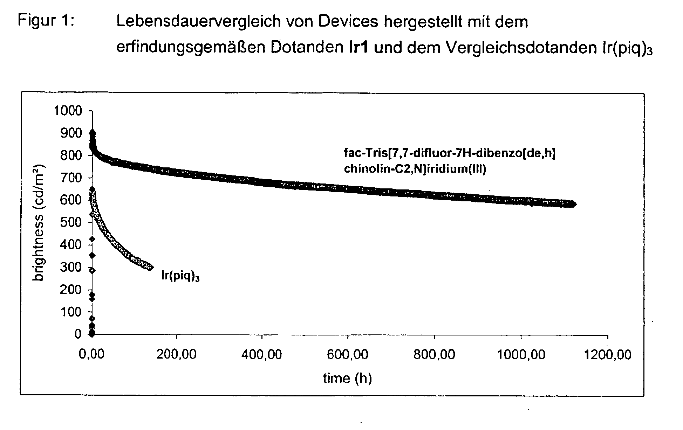

Die beiden Lebensdauerkurven (Abb. 1) wurden zur besseren Vergleichbarkeit in derselben Figur dargestellt. Die Figur zeigt den Verlauf der Helligheit, gemessen in cd/m², mit der Zeit. Die Messung erfolgte bei konstanter Stromdichte von 10 mA/cm² bei einer Temperatur von 80 °C, was einer beschleunigten Messung entspricht. Als Lebensdauer bezeichnet man die Zeit, nach der 50 % der Anfangsleuchtdichte erreicht werden.
Man erhält bei den gezeigten Helligkeiten für den Dotanden Ir(piq)₃ eine Lebensdauer von ca. 130 h bei einer Anfangshelligkeit von ca. 650 cd/m². Für den Dotanden Ir1 erhält man bei derselben Stromdichte eine Anfangshelligkeit von ca. 900 cd/m² und eine Lebensdauer größer 5.000 h bei 80 °C, was einer Steigerung der Lebensdauer um einen Faktor von fast 40 gegenüber den OLEDs mit Ir(piq)₃ als Dotanden entspricht.

### Beispiele 8 bis 11: Weitere Device-Beispiele mit erfindungsgemäßen Dotanden

Auch die weiteren erfindungsgemäßen Dotanden **Ir2** bis **Ir5** wurden in OLEDs getestet und mit Ir(piq)₃ gemäß dem Stand der Technik (Beispiel 8) verglichen. Analog dem in Beispiel 7 aufgeführten Verfahren wurden OLEDs mit folgendem Aufbau erzeugt:

| | |
|---|---|
| PEDOT | 80 nm (aus Wasser aufgeschleudert; PEDOT bezogen von H. C. Starck, Goslar; Poly-[3,4-ethylendioxy-2,5-thiophen]), (HIL) |
| NaphDATA | 20 nm (aufgedampft; NaphDATA bezogen von SynTec; 4,4',4"-Tris(N-1-naphthyl)-N-phenyl-amino)-triphenylamin), (HTL) |
| S-TAD | 20 nm (aufgedampft; S-TAD synthetisiert nach WO99/12888; 2,2',7,7'-Tetrakis(diphenylamino)-spirobifluoren), (HTL) |
| Emitter-Schicht: | (EML) |
| **M1** | Bis(9,9'-spirobifluoren-2-yl)keton (aufgedampft, synthetisiert nach DE 10317556.3) |
| **Ir2** bis **Ir5** | (aufgedampft; synthetisiert nach Beispiel 2 bis 5) |
| ODER: | |
| Ir(piq)₃ | (aufgedampft; synthetisiert nach Beispiel 6) |
| **HBM1** | 2,7-Bis(4-biphenyl-1-yl)-2',7'-di-tert-butyl-spiro-9,9'-bifluoren (aufgedampft; synthetisiert nach DE 10357317.8), (HBL); nicht in allen Beispielen verwendet |
| AlQ₃ | (aufgedampft; AlQ₃ bezogen von SynTec; Tris(chinolinato)aluminium(III), (ETL)); nicht in allen Beispielen verwendet |
| Ba-Al | 3 nm Ba, darauf 150 nm Al. |

Dabei wurden die Schichtdicken so gewählt, dass die Gesamtschichtdicke der Emissionsschicht, der Lochblockierschicht und der Elektronentransportschicht insgesamt immer 60 nm ergab. Die Ergebnisse, die mit diesen OLEDs erhalten wurden, sind in Tabelle 1 zusammengefasst. Das Matrixmaterial **M1**, das Lochblockiermaterial **HBM1** und der Vergleichsdotand Ir(piq)₃ sind im folgenden der Übersichtlichkeit halber abgebildet:

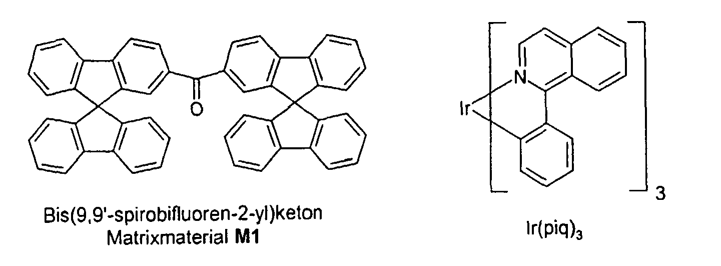

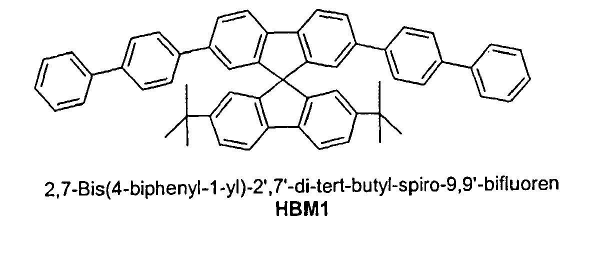

**Tabelle 1: Device-Ergebnisse mit erfindungsgemäßen Dotanden**

| Experiment | EML | HBL | ETL | Max. Effizienz [cd/A] | Max. Leistungseffizienz [Im/W] | Spannung [V] bei 100 cd/m² | CIE (x, y) | Lebensdauer [h] bei 10 mA/cm² |
|---|---|---|---|---|---|---|---|---|
| Beispiel 8a (Vergleich) | **M1**:10% Ir(piq)₃ (30 nm) | **HBM1** (10 nm) | AlQ₃ (20 nm) | 7.4 | 5.3 | 5.8 | 0.68/0.32 | 10200 |
| Beispiel 8b (Vergleich) | **M1**:10% Ir(piq)₃ (60 nm) | - | - | 7.1 | 6.9 | 3.9 | 0.68/0.32 | 7400 |
| Beispiel 9a | **M1**:10% **Ir3** (30 nm) | **HBM1** (10 nm) | AlQ₃ (20 nm) | 10.3 | 7.5 | 5.7 | 0.66/0.34 | 12700 |
| Beispiel 9b | **M1**:10% **Ir3** (40 nm) | - | AlQ₃ (20 nm) | 11.8 | 7.9 | 5.2 | 0.66/0.34 | 11900 |
| Beispiel 9c | **M1**:10% **Ir3** (60 nm) | - | - | 14.9 | 11.0 | 4.0 | 0.66/0.34 | 9400 |
| Beispiel 10a | **M1**:10% **Ir2** (30 nm) | **HBM1** (10 nm) | AlQ₃ (20 nm) | 13.4 | 8.9 | 5.5 | 0.64/0.36 | 12200 |
| Beispiel 11a | **M1**:10% **Ir5** (30 nm) | **HBM1** (10 nm) | AlQ₃ (20 nm) | 12.4 | 6.7 | 5.9 | 0.65/0.35 | 11600 |
| Beispiel 11b | **M1**:10% **Ir5** (60 nm) | - | - | 13.4 | 7.9 | 4.2 | 0.65/0.35 | 9800 |

## Patentansprüche

1. Verbindungen gemäß Formel (1),
M(L)ₙ(L')ₘ(L")ₒ Formel (1)
enthaltend eine Teilstruktur M(L)ₙ der Formel (2a), 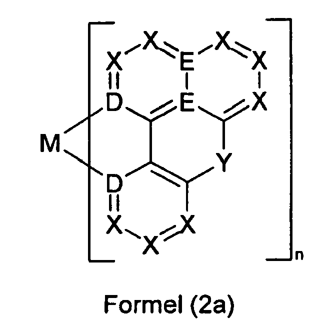 wobei für die verwendeten Symbole und Indizes gilt:
M ist bei jedem Auftreten Ir oder Pt;
Y ist gleich oder verschieden bei jedem Auftreten SR¹, CR₂, C=O, C=CR₂, SiR¹₂, NR¹, PR¹, P(O)R¹, O oder eine Einfachbindung;
D ist gleich oder verschieden bei jedem Auftreten ein Kohlenstoffatom oder ein Stickstoffatom, mit der Maßgabe, daß ein D für ein Kohlenstoffatom steht und das andere D für ein Stickstoffatom;
X ist gleich oder verschieden bei jedem Auftreten CR oder N; oder eine oder mehrere Einheiten X-X steht für NR oder S; oder eine Einheit X-X in den kondensierten Teilcyclen steht für CR oder N, falls eines der Symbole E für N steht;
E ist gleich oder verschieden bei jedem Auftreten C oder N mit der Maßgabe, daß mindestens ein Symbol E für C steht und weiterhin mit der Maßgabe, daß genau eine Einheit X-X in den kondensierten Teilcyclen, welche das Symbol E enthalten, gleich CR ist, falls ein Symbol E für N steht;
R ist gleich oder verschieden bei jedem Auftreten H, F, Cl, Br, I, OH, NO₂, CN, eine geradkettige, verzweigte oder cyclische Alkyl- oder Alkoxygruppe mit 1 bis 20 C-Atomen, wobei eine oder mehrere nicht benachbarte CH₂-Gruppen durch -R¹C=CR¹-, -C≡C-, Si(R¹)₂, Ge(R¹)₂, Sn(R¹)₂, -O-, -S-, -NR¹-, -(C=O)-, -(C=NR¹)-, -P=O(R¹)- oder -CONR¹- ersetzt sein können und wobei ein oder mehrere H-Atome durch F ersetzt sein können, oder eine Aryl-, Heteroaryl-, Aryloxy- oder Heteroaryloxygruppe mit 1 bis 14 C-Atomen, die durch einen oder mehrere nicht-aromatische Reste R substituiert sein kann, wobei mehrere Substituenten R, sowohl am selben Ring als auch an unter- schiedlichen Ringen zusammen, wiederum ein weiteres mono- oder poly- cyclisches, aliphatisches oder aromatisches Ringsystem aufspannen können;
R¹ ist gleich oder verschieden bei jedem Auftreten H oder ein aliphatischer oder aromatischer Kohlenwasserstoffrest mit 1 bis 20 C-Atomen;
n ist 1, 2 oder 3;
dabei sind die Liganden L' und L" in Formel (1) monoanionische, zweizähnig chelatisierende Liganden und m und o sind gleich oder verschieden bei jedem Auftreten 0, 1 oder 2.

2. Verbindungen der Formel (1 a) gemäß Anspruch 1,
M(L)ₙ(L')ₘ(L")ₒ Formel (1a)
enthaltend mindestens eine Teilstruktur M(L)ₙ der Formel (2b), gleich oder verschieden bei jedem Auftreten, 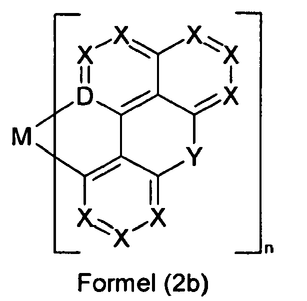 und gegebenenfalls enthaltend eine Teilstruktur M(L')ₘ der Formel (3), gleich oder verschieden bei jedem Auftreten, 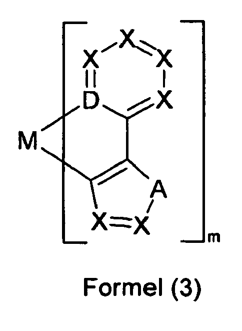 wobei M, X, Y, R, R¹, L", n, m und o dieselbe Bedeutung haben, wie in Anspruch 1 beschrieben, und die weiteren Symbole und Indizes folgende Bedeutung haben:
D ist bei jedem Auftreten N;
A ist gleich oder verschieden bei jedem Auftreten -CR=CR-, -N=CR-, -N=N-, NR, O, S.

3. Verbindungen gemäß Anspruch 1 oder 2, **dadurch gekennzeichnet, daß** das Symbol n = 2 oder 3 bedeutet.

4. Verbindungen gemäß einem oder mehreren der Ansprüche 1 bis 3, **dadurch gekennzeichnet, daß** das Symbol X = CR bedeutet.

5. Verbindungen gemäß einem oder mehreren der Ansprüche 1 bis 4, **dadurch gekennzeichnet, daß** das Symbol Y = CR₂, C=O, C=CR₂, NR¹, PR¹, P(O)R¹, O oder eine Einfachbindung darstellt.

6. Verbindungen gemäß einem oder mehreren der Ansprüche 1 bis 5, **dadurch gekennzeichnet, daß** für R gilt:
R ist gleich oder verschieden bei jedem Auftreten H, F eine geradkettige, verzweigte oder cyclische Alkyl- oder Alkoxygruppe mit 1 bis 4 C-Atomen, wobei ein oder mehrere H-Atome durch F ersetzt sein können, oder eine Aryl- oder Heteroarylgruppe mit 1 bis 6 C-Atomen, die durch einen oder mehrere, nicht-aromatische Reste R substituiert sein kann, wobei mehrere Substituenten R, sowohl am selben Ring als auch an unterschiedlichen Ringen zusammen wiederum ein weiteres aliphatisches oder aromatisches, mono- oder polycyclisches Ringsystem aufspannen können.

7. Verbindungen gemäß einem oder mehreren der Ansprüche 1 bis 6, **dadurch gekennzeichnet, daß** Y ein Spiro-C-Atom darstellt.

8. Verbindungen gemäß Formel (4a), 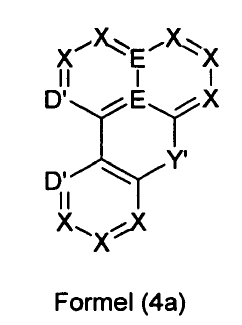 wobei die Symbole E und X dieselbe Bedeutung haben, wie in Anspruch 1 beschrieben, und für die weiteren Symbole gilt:
Y' ist gleich oder verschieden bei jedem Auftreten SR¹, CR₂, C=NR¹, C=CR₂, SiR¹₂, PR¹, P(O)R¹.
D' ist gleich oder verschieden bei jedem Auftreten C-H oder N, mit der Maßgabe, daß ein Symbol D' für C-H steht und das andere Symbol D' für N steht.

9. Verbindungen gemäß Formel (4b) gemäß Anspruch 8, 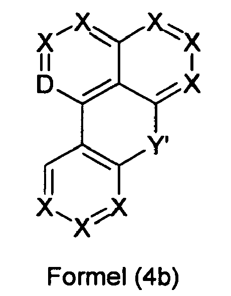 wobei D für N steht und die weiteren Symbole dieselbe Bedeutung haben, wie in Anspruch 1 und 8 beschrieben.

10. Verfahren zur Herstellung der Verbindungen gemäß einem oder mehreren der Ansprüche 1 bis 7 durch Umsetzung der Verbindungen gemäß Formel (4a) oder (4b) gemäß Anspruch 8 oder 9 mit Metallalkoholaten der Formel (5), mit Metallketoketonaten der Formel (6) oder ein- oder mehrkernigen Metallhalogeniden der Formel (7), (8) und (9), 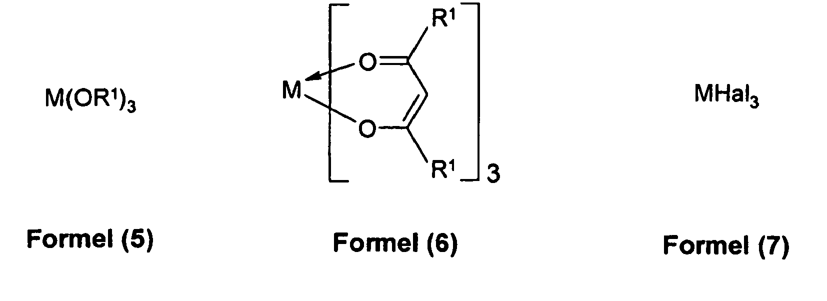 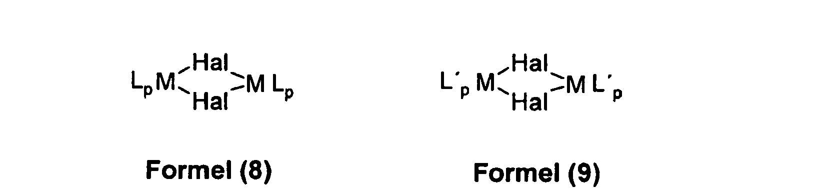 wobei die Symbole M und R¹ die unter Anspruch 1 angegebene Bedeutung haben, p = 1 oder 2 ist und Hal = F, Cl, Br oder I ist.

11. Verfahren zur Herstellung der Verbindungen gemäß Formel (1) oder (1a) gemäß einem oder mehreren der Ansprüche 1 bis 7 durch Umsetzung der Verbindungen gemäß Formel (4a) oder (4b) gemäß Anspruch 8 oder 9 mit Iridiumverbindungen, die sowohl Alkoholat- und/oder Halogenid- und/oder Hydroxy- wie auch Ketoketonatreste tragen.

12. Verbindungen gemäß einem oder mehreren der Ansprüche 1 bis 9, **dadurch gekennzeichnet, daß** ihre Reinheit (bestimmt mittels ¹H-NMR und/oder HPLC) mehr als 99 % beträgt.

13. Konjugierte, teilkonjugierte oder nicht-konjugierte Polymere oder Dendrimere enthaltend eine oder mehrere der Verbindungen gemäß einem oder mehreren der Ansprüche 1 bis 7.

14. Polymere oder Dendrimere gemäß Anspruch 13, **dadurch gekennzeichnet, daß** mindestens ein in Anspruch 1 definiertes R eine Bindung zum Polymer oder Dendrimer darstellt.

15. Polymere gemäß Anspruch 13 oder 14, **dadurch gekennzeichnet, daß** das Polymer aus der Gruppe Polyfluorene, Poly-spirobifluorene, Poly-para-phenylene, Poly-carbazole, Poly-vinylcarbazole, Polythiophene, Polyketone oder auch aus Copolymeren, die mehrere der hier genannten Einheiten aufweisen, ausgewählt ist.

16. Verwendung einer Verbindung gemäß einem oder mehreren der Ansprüche 1 bis 7 und/oder 12 bis 15 in elektronischen Bauteilen.

17. Elektronisches Bauteil enthaltend mindestens eine Verbindung gemäß einem oder mehreren der Ansprüche 1 bis 7 und/oder 12 bis 15.

18. Elektronisches Bauteil gemäß Anspruch 17, **dadurch gekennzeichnet, daß** es sich um eine organische Leuchtdiode (OLED), eine organische integrierte Schaltung (O-IC), einen organischen Feld-Effekt-Transistor (O-FET), einen organischen Dünnfilmtransistor (O-TFT), eine organische Solarzelle (O-SC) oder eine organische Laserdiode (O-Laser) handelt.

## Claims

1. Compounds of the formula (1),
M(L)ₙ(L')ₘ(L")ₒ formula (1)
containing a moiety M(L)ₙ of the formula (2a), 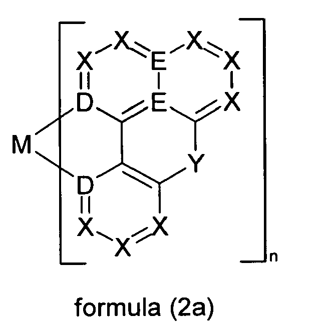 where the following applies to the symbols and indices used:
M is on each occurrence Ir or Pt;
Y is, identically or differently on each occurrence, BR¹, CR₂, C=O, C=CR₂, SiR¹₂, NR¹, PR¹, P(O)R¹, O or a single bond;
D is, identically or differently on each occurrence, a carbon atom or a nitrogen atom, with the proviso that one D stands for a carbon atom and the other D stands for a nitrogen atom;
X is, identically or differently on each occurrence, CR or N; or one or more units X-X stand for NR or S; or one unit X-X in the fused ring moieties stands for CR or N if one of the symbols E stands for N;
E is, identically or differently on each occurrence, C or N, with the proviso that at least one symbol E stands for C and furthermore with the proviso that pre- cisely one unit X-X in the fused ring moieties which contain the symbol E is equal to CR if one symbol E stands for N;
R is, identically or differently on each occurrence, H, F, Cl, Br, I, OH, NO₂, CN, a straight-chain, branched or cyclic alkyl or alkoxy group having 1 to 20 C atoms, where one or more non-adjacent CH₂ groups may be replaced by -R¹C=CR¹-, -C≡C-, Si(R¹)₂, Ge(R¹)₂, Sn(R¹)₂, -O-, -S-, -NR¹-, -(C=O)-, -(C=NR¹)-, -P=O(R¹)- or -CONR¹- and where one or more H atoms may be replaced by F, or an aryl, heteroaryl, aryloxy or heteroaryloxy group having 1 to 14 C atoms, which may be substituted by one or more non-aromatic radi- cals R, where a plurality of substituents R, both on the same ring and also on different rings, may together in turn form a further mono- or polycyclic, ali- phatic or aromatic ring system;
R¹ is, identically or differently on each occurrence, H or an aliphatic or aromatic hydrocarbon radical having 1 to 20 C atoms;
n is 1, 2 or 3;
the ligands L' and L" in formula (1) are monoanionic, bidentate-chelating ligands, and m and o are, identically or differently on each occurrence, 0, 1 or 2.

2. Compounds of the formula (1a) according to Claim 1,
M(L)ₙ(L')ₘ(L")ₒ formula (1a)
containing at least one moiety M(L)ₙ of the formula (2b), identically or differently on each occurrence, 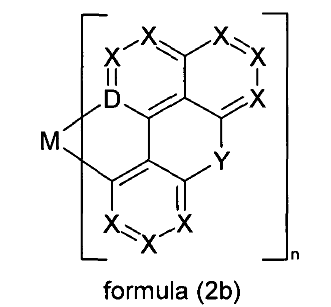 and optionally containing a moiety M(L')ₘ of the formula (3), identically or differently on each occurrence, 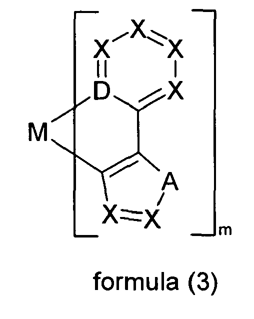 where M, X, Y, R, R¹, L", n, m and o have the same meaning as described in Claim 1, and the other symbols and indices have the following meaning:
D is on each occurrence N;
A is, identically or differently on each occurrence, -CR=CR-, -N=CR-, -N=N-, NR, O, S.

3. Compounds according to Claim 1 or 2, **characterised in that** the symbol n = 2 or 3.

4. Compounds according to one or more of Claims 1 to 3, **characterised in that** the symbol X = CR.

5. Compounds according to one or more of Claims 1 to 4, **characterised in that** the symbol Y = CR₂, C=O, C=CR₂, NR¹, PR¹, P(O)R¹, O or a single bond.

6. Compounds according to one or more of Claims 1 to 5, **characterised in that** the following applies to R:
R is, identically or differently on each occurrence, H, F, a straight-chain, branched or cyclic alkyl or alkoxy group having 1 to 4 C atoms, where one or more H atoms may be replaced by F, or an aryl or heteroaryl group having 1 to 6 C atoms, which may be substituted by one or more non-aromatic radicals R, where a plurality of substituents R, both on the same ring and also on different rings, may together in turn form a further aliphatic or aromatic, mono- or poly- cyclic ring system.

7. Compounds according to one or more of Claims 1 to 6, **characterised in that** Y represents a spiro C atom.

8. Compounds of the formula (4a), 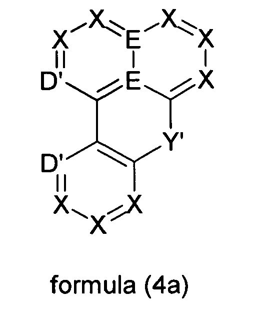 where the symbols E and X have the same meaning as described in Claim 1, and the following applies to the other symbols:
Y' is, identically or differently on each occurrence, BR¹, CR₂, C=NR¹, C=CR₂, SiR¹₂, PR¹, P(O)R¹;
D' is, identically or differently on each occurrence, C-H or N, with the proviso that one symbol D' stands for C-H and the other symbol D' stands for N.

9. Compounds of the formula (4b) according to Claim 8, 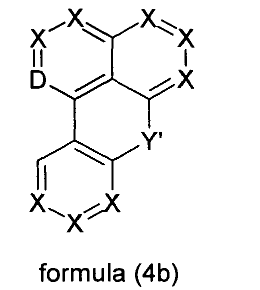 where D stands for N and the other symbols have the same meaning as described in Claims 1 and 8.

10. Process for the preparation of the compounds according to one or more of Claims 1 to 7 by reaction of the compounds of the formula (4a) or (4b) according to Claim 8 or 9 with metal alkoxides of the formula (5), with metal ketoketonates of the formula (6) or mono- or polycyclic metal halides of the formulae (7), (8) and (9), 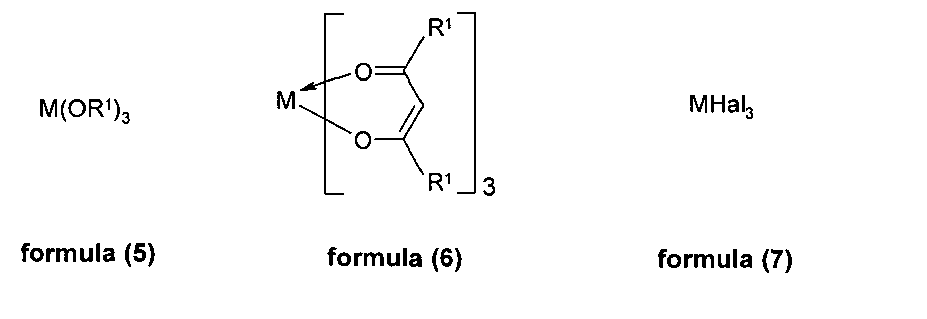 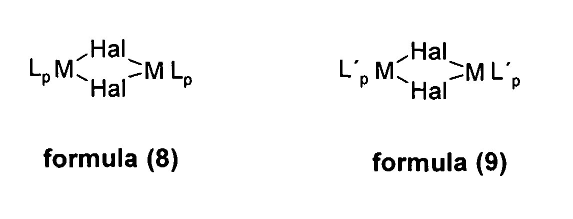 where the symbols M and R¹ have the meaning indicated under Claim 1, p = 1 or 2, and Hal = F, Cl, Br or I.

11. Process for the preparation of the compounds of the formula (1) or (1a) according to one or more of Claims 1 to 7 by reaction of the compounds of the formula (4a) or (4b) according to Claim 8 or 9 with iridium compounds which carry both alkoxide and/or halide and/or hydroxyl and ketoketonate radicals.

12. Compounds according to one or more of Claims 1 to 9, **characterised in that** their purity (determined by means of ¹H-NMR and/or HPLC) is greater than 99%.

13. Conjugated, partially conjugated or non-conjugated polymers or dendrimers containing one or more of the compounds according to one or more of Claims 1 to 7.

14. Polymers or dendrimers according to Claim 13, **characterised in that** at least one R defined in Claim 1 represents a bond to the polymer or dendrimer.

15. Polymers according to Claim 13 or 14, **characterised in that** the polymer is selected from the group polyfluorenes, polyspirobifluorenes, poly-para-phenylenes, polycarbazoles, polyvinylcarbazoles, polythiophenes, polyketones or also from copolymers which have a plurality of the units mentioned here.

16. Use of a compound according to one or more of Claims 1 to 7 and/or 12 to 15 in electronic components.

17. Electronic component containing at least one compound according to one or more of Claims 1 to 7 and/or 12 to 15.

18. Electronic component according to Claim 17, **characterised in that** it is an organic light-emitting diode (OLED), an organic integrated circuit (O-IC), an organic field-effect transistor (O-FET), an organic thin-film transistor (O-TFT), an organic solar cell (O-SC) or an organic laser diode (O-laser).

## Revendications

1. Composés de la formule (1),
M(L)ₙ(L')ₘ(L")ₒ formule (1)
contenant une moitié M(L)ₙ de la formule (2a), 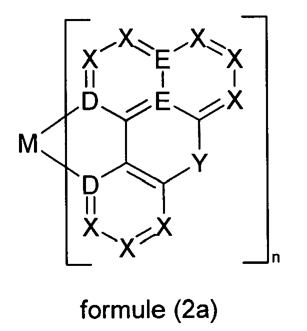 dans laquelle ce qui suit s'applique aux symboles et indices utilisés:
M est, pour chaque occurrence, Ir ou Pt;
Y est, de manière identique ou différente pour chaque occurrence, BR¹, CR₂, C=O, C=CR₂, SiR¹₂, NR¹, PR¹, P(O)R¹, O ou une liaison simple;
D est, de manière identique ou différente pour chaque occurrence, un atome de carbone ou un atome d'azote, sous réserve qu'un D représente un atome de carbone et l'autre D représente un atome d'azote;
X est, de manière identique ou différente pour chaque occurrence, CR ou N; ou une ou plusieurs unités X-X représentent NR ou S; ou une unité X-X in dans les moitiés de cycle fusionnées représente CR ou N si l'un des sym- boles E représente N;
E est, de manière identique ou différente pour chaque occurrence, C ou N, sous réserve qu'au moins un symbole E représente C et en outre, sous réserve que précisément une unité X-X dans les moitiés de cycle fusionnées qui contiennent le symbole E est égale à CR si un symbole E représente N;
R est, de manière identique ou différente pour chaque occurrence, H, F, Cl, Br, I, OH, NO₂, CN, un groupe alkyle ou alcoxy en chaîne droite, ramifié ou cyclique comportant de 1 à 20 atomes de C, où un ou plusieurs groupes CH₂ non adjacents peut/peuvent être remplacé(s) par -R¹C=CR¹-, -C≡C-, Si(R¹)₂, Ge(R¹)₂, Sn(R¹)₂, -O-, -S-, -NR¹-, -(C=O)-, -(C=NR¹)-, -P=O(R¹)- ou -CONR¹- et où un ou plusieurs atomes de H peut/peuvent être remplacé(s) par F, ou un groupe aryle, hétéroaryle, aryloxy ou hétéroaryloxy comportant de 1 à 14 atomes de C, lequel peut être substitué par un ou plusieurs radicaux R non aromatiques, où une pluralité de substituants R, à la fois sur le même cycle et également sur des cycles différents, peuvent ensemble à leur tour former un autre système de cycle mono- ou polycyclique, aliphatique ou aroma- tique;
R¹ est, de manière identique ou différente pour chaque occurrence, H ou un radical hydrocarbone aliphatique ou aromatique comportant de 1 à 20 atomes de C;
n est 1, 2 ou 3;
les ligands L' et L" dans la formule (1) sont des ligands monoanioniques, bidentés-chélatants, et m et o sont, de manière identique ou différente pour chaque occurrence, 0, 1 ou 2.

2. Composés de la formule (1a) selon la revendication 1,
M(L)ₙ(L')ₘ(L")ₒ formule (1a)
contenant au moins une moitié M(L)ₙ de la formule (2b), de manière identique ou différente pour chaque occurrence, 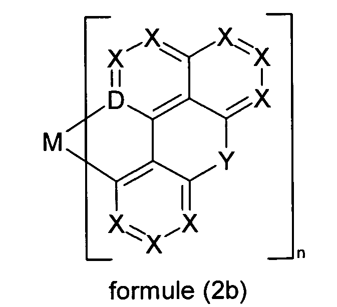 et en option, contenant une moitié M(L')ₘ de la formule (3), de manière identique ou différente pour chaque occurrence, 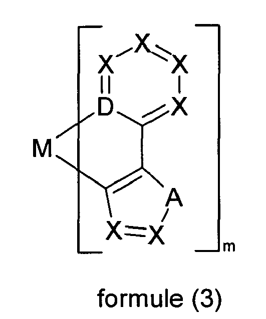 où M, X, Y, R, R¹, L", n, m et o présentent la même signification que décrit selon la revendication 1, et les autres symboles et indices présentent la signification qui suit:
D est pour chaque occurrence N;
A est, de manière identique ou différente pour chaque occurrence, -CR=CR-, -N=CR-, -N=N-, NR, O, S.

3. Composés selon la revendication 1 ou 2, **caractérisés en ce que** le symbole n = 2 ou 3.

4. Composés selon une ou plusieurs des revendications 1 à 3, **caractérisés en ce que** le symbole X = CR.

5. Composés selon une ou plusieurs des revendications 1 à 4, **caractérisés en ce que** le symbole Y = CR₂, C=O, C=CR₂, NR¹, PR¹, P(O)R¹, O ou une liaison simple.

6. Composés selon une ou plusieurs des revendications 1 à 5, **caractérisés en ce** qui suit s'applique à R:
R est, de manière identique ou différente pour chaque occurrence, H, F, un groupe alkyle ou alcoxy en chaîne droite, ramifié ou cyclique comportant de 1 à 4 atomes de C, où un ou plusieurs atomes de H peut/peuvent être rem- placé(s) par F, ou un groupe aryle ou hétéroaryle comportant de 1 à 6 atomes de C, lequel peut être substitué par un ou plusieurs radicaux R non aromatiques, où une pluralité de substituants R, à la fois sur le même cycle et également sur des cycles différents, peuvent ensemble à leur tour former un autre système de cycle aliphatique ou aromatique, mono- ou polycycli- que.

7. Composés selon une ou plusieurs des revendications 1 à 6, **caractérisés en ce que** Y représente un atome de C spiro.

8. Composés de la formule (4a), 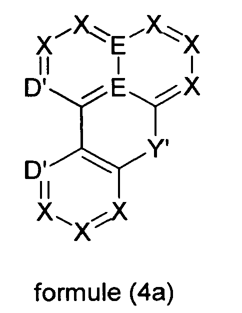 où les symboles E et X présentent la même signification que décrit selon la revendication 1, et ce qui suit s'applique aux autres symboles:
Y' est, de manière identique ou différente pour chaque occurrence, BR¹, CR₂, C=NR¹, C=CR₂, SiR¹₂, PR¹, P(O)R¹;
D' est, de manière identique ou différente pour chaque occurrence, C-H ou N, étant entendu qu'un symbole D' représente C-H et que l'autre symbole D' représente N.

9. Composés de la formule (4b) selon la revendication 8, 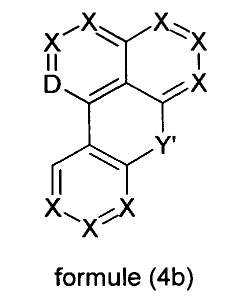 où D représente N et les autres symboles présentent la même signification que décrit selon les revendications 1 et 8.

10. Procédé pour la préparation des composés selon une ou plusieurs des revendications 1 à 7 par réaction des composés de la formule (4a) ou (4b) selon la revendication 8 ou 9 avec des alcoxydes métalliques de la formule (5), avec des cétocétonates métalliques de la formulé (6) ou des halogénures métalliques mono- ou polycycliques des formules (7), (8) et (9), 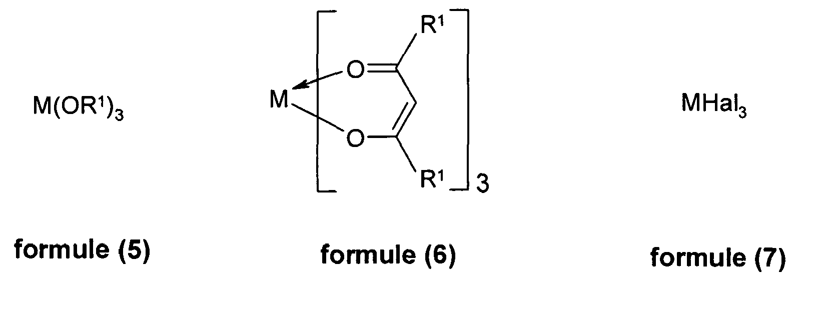 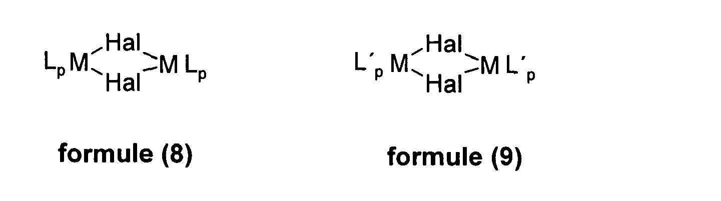 où les symboles M and R¹ présentent la signification indiquée sous la revendication 1, p = 1 ou 2, et Hal = F, CI, Br ou I.

11. Procédé pour la préparation des composés de la formule (1) ou (1 a) selon une ou plusieurs des revendications 1 à 7 par réaction des composés de la formule (4a) ou (4b) selon la revendication 8 ou 9 avec des composés d'iridium qui sont porteurs de radicaux à la fois alcoxyde et/ou halogénure et/ou hydroxyle et cétocétonate.

12. Composés selon une ou plusieurs des revendications 1 à 9, **caractérisés en ce que** leur pureté (déterminée au moyen de ¹H-NMR et/ou HPLC) est supérieure à 99%.

13. Polymères ou dendrimères conjugués, partiellement conjugués ou non conjugués contenant un ou plusieurs des composés selon une ou plusieurs des revendications 1 à 7.

14. Polymères ou dendrimères selon la revendication 13, **caractérisés en ce qu'**au moins un R défini selon la revendication 1 représente une liaison sur le polymère ou dendrimère.

15. Polymères selon la revendication 13 ou 14, **caractérisés en ce que** le polymère est choisi parmi le groupe des polyfluorènes, des polyspirobifluorènes, des poly-para-phénylènes, des polycarbazoles, des polyvinylcarbazoles, des polythiophènes, des polycétones ou également parmi des copolymères qui comportent une pluralité des unités mentionnées ici.

16. Utilisation d'un composé selon une ou plusieurs des revendications 1 à 7 et/ou 12 à 15 dans des composants électroniques.

17. Composant électronique contenant au moins un composé selon une ou plusieurs des revendications 1 à 7 et/ou 12 à 15.

18. Composant électronique selon la revendication 17, **caractérisé en ce qu'**il s'agit d'une diode émettrice de lumière organique (OLED), d'un circuit intégré organique (O-IC), d'un transistor à effet de champ organique (O-FET), d'un transistor à film mince organique (O-TFT), d'une cellule solaire organique (O-SC) ou d'une diode laser organique (O-laser).
